(19) Europäisches Patentamt

European Patent Office

Office européen des brevets

(11) EP 0 758 782 B1

(12) **EUROPEAN PATENT SPECIFICATION**

(45) Date of publication and mention
of the grant of the patent:
**19.11.2003 Bulletin 2003/47**

(51) Int Cl.$^7$: **G11B 5/02**, G11B 5/00,
G11B 20/10, G11B 5/09

(21) Application number: **96303846.8**

(22) Date of filing: **29.05.1996**

(54) **Magnetic recording device and method**

Verfahren und Vorrichtung zur magnetischen Aufzeichnung

Dispositif et méthode d'enregistrement magnétique

(84) Designated Contracting States:
**DE FR GB**

(30) Priority: **16.08.1995 KR 9525126**
**22.09.1995 KR 9531350**
**27.02.1996 KR 9604916**

(43) Date of publication of application:
**19.02.1997 Bulletin 1997/08**

(73) Proprietor: **Samsung Electronics Co., Ltd.**
**Suwon-city, Kyungki-do 441-370 (KR)**

(72) Inventors:
• **Soichi, Iwamura**
**Suwon-city, Kyunki-do (KR)**

• **Jeon, Jin-kyu**
**Suwon-city, Kyungki-do (KR)**

(74) Representative: **Chugg, David John et al**
**Appleyard Lees,**
**15 Clare Road**
**Halifax, West Yorkshire HX1 2HY (GB)**

(56) References cited:
**EP-A- 0 155 743        EP-A- 0 656 684**
**US-A- 5 333 081**

• **PATENT ABSTRACTS OF JAPAN vol. 010, no.
015 (P-422), 21 January 1986 & JP 60 170006 A
(MATSUSHITA DENKI SANGYO KK), 3
September 1985,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to a magnetic recording device and method, and more particularly, to a magnetic recording device and method in which a magnetic head records audio and video information on a magnetic recording medium by using a low power-consumption recording amplifier suited for a high-speed and high-density recording.

Magnetic recording of information is accomplished by generating a magnetic flux by means of a head current flowing through a magnetic head and thus magnetizing a magnetic recording medium. Generally, a recording amplifier of a constant current source is used to supply a current of an intended signal waveform to a magnetic head having an inductive impedance. To obtain the intended current signal waveform, its corresponding voltage signal waveform should be generated in a signal processor, in advance.

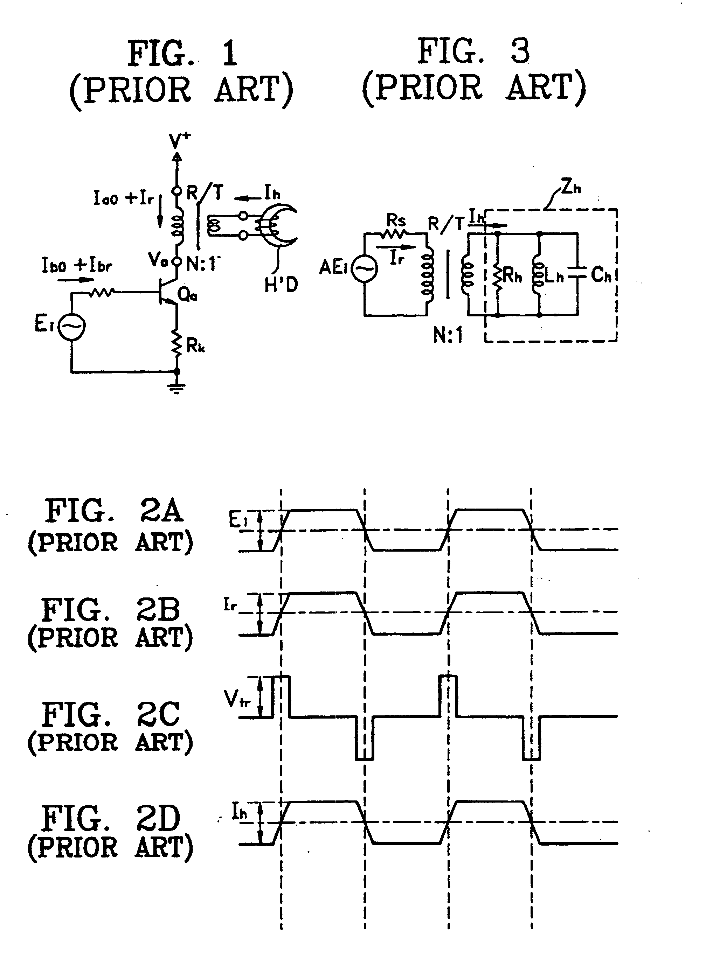

Figure 1 is a circuit diagram of a conventional A-class single-ended recording amplifier.

As shown in the figure, a current feedback resistor $R_k$ is connected to the emitter of an amplifying transistor $Q_a$. To the base of the transistor $Q_a$ is applied an input voltage signal $E_i$ and are injected a bias current $I_{bo}$ and a base current $I_{br}$ corresponding to the input voltage signal $E_i$ shown in Figure 2A. The transistor $Q_a$ operates by this base current $I_{br}$. Therefore, a collector alternate current (AC) component $I_a$, i.e., a recording current $I_r$ shown in Figure 2B, as well as a direct current (DC) component $I_{ao}$ corresponding to the bias current $I_{bo}$ are supplied to the primary part of a rotary transformer (hereinafter referred to as R/T), and a head current $I_h$ shown in Figure 2D flows in the secondary side of the R/T.

Meanwhile, when a binary coded recording current $I_r$, indicative of binary coded information, flows and is switched in an inductance load such as the magnetic head, a transient pulse voltage $V_{tr}$ shown in Figure 2C is generated across the head, in this case at the collector of the transistor $Q_a$. To prevent the waveform of a collector voltage $V_a$ from being distorted, the transistor $Q_a$ should function as an A-class amplifier by assigning its operation quiescent point on a linear portion of its characteristic curve.

In the A-class recording amplifier shown in Figure 1,

$$E_i \simeq I_a R_k, \text{ or } I_a/E_i \simeq \text{constant} \tag{1}$$

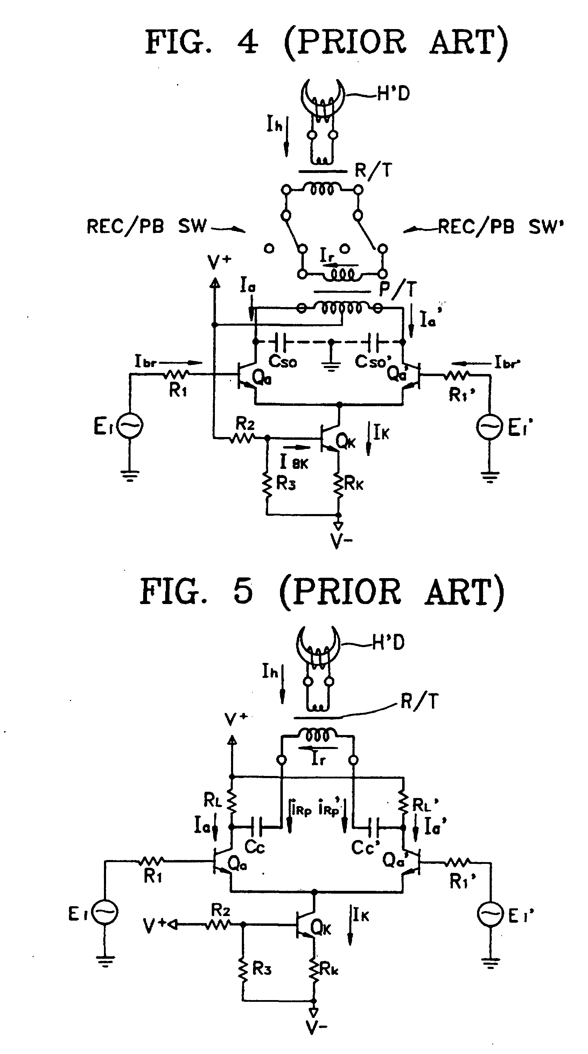

The recording amplifier of Figure 1 can be approximated to an equivalent circuit of Figure 3, in which a head impedance $Z_h$ being an inductive impedance is generated by connecting in parallel with one another an equivalent inductor $L_h$, a loss resistor $R_h$, and an equivalent capacitor $C_h$. Assuming that an upper limit frequency of a transmission band is $f_m$ and the ratio of the number of windings at the primary side to that of windings at the secondary side of the R/T is N,

$$R_h/(2\pi f_m L_h) \simeq (3{\sim}4) >> 1 \tag{2}$$

Since the load of the transistor $Q_a$ of Figure 1 is an inductive impedance, an output impedance $R_s$ of the transistor $Q_a$ should be larger than the head impedance $Z_h$ to flow the predetermined head current $I_h$.

$$R_s >> |Z_h|, \text{ or } R_s >> 2\pi f_m L_h \tag{3}$$

Given an amplification degree as A, the recording current I, output from the transistor $Q_a$ is calculated by

$$I_r = A \cdot E_i / (R_s + Z_h) \simeq A \cdot E_i / R_s \tag{4}$$

$$Z_h = R_h \cdot j2\pi L_h / (R_h + j2\pi L_h)$$

$$\doteqdot j2\pi L_h \tag{5}$$

Accordingly, a recording-equalization compensation can be performed in the linear amplifier of Figure 1 for providing the head current $I_h$ proportional to the input voltage signal $E_i$.

In this case, with the upper limit frequency $f_m$ of an effective band, the condition such that $R_s >> |Z_h|$ should be satisfied based on the premise that $R_h \rangle 2\pi f_m L_h$ and $2\pi f_m \langle \sqrt{(L_h C_h)}$.

Figure 4 illustrates a B-class push-pull recording amplifier having a pulse transformer (hereinafter referred to as P/T), and Figure 5 illustrates a B-class push-pull recording amplifier without the P/T.

In the B-class push-pull recording amplifier of Figure 4, the collector of a transistor $Q_k$ having a current feedback emitter resistor $R_k$, for controlling a constant current, is connected to a common emitter of transistors $Q_a$ and $Q_a'$ exhibiting high-power impedance characteristics. Since the recording amplifier is a push-pull type, DC components can be cancelled and, practically, neglected at the primary side of the P/T.

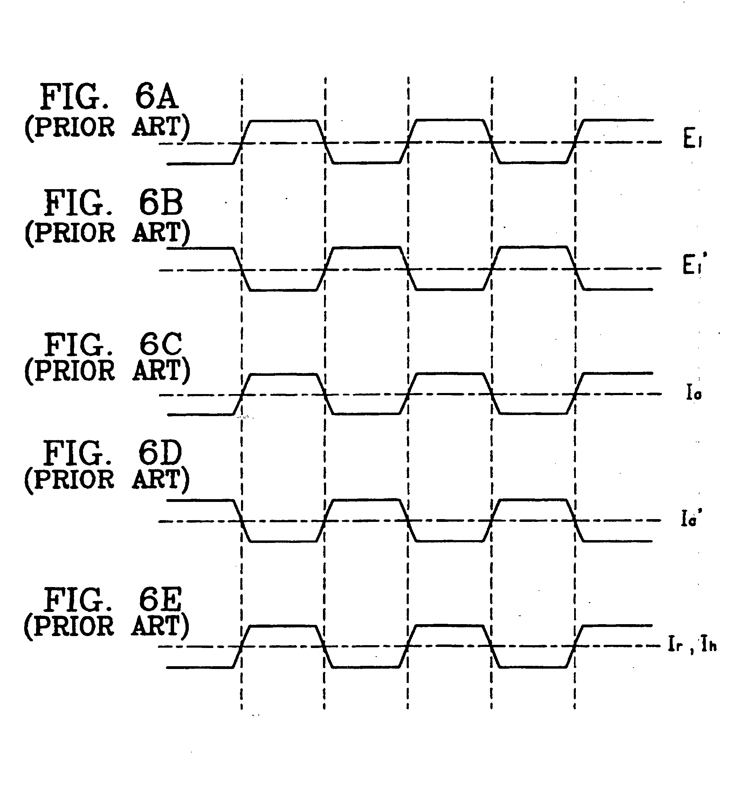

Base currents $I_{br}$ and $I_{br}'$ generated by input voltage signals $E_i$ and $E_i'$ shown in Figures 6A and 6B are injected to the respective bases of the transistors $Q_a$ and $Q_a$, thus alternately turning on and off the transistors $Q_a$ and $Q_a'$.

A predetermined recording current $I_a$ shown in Figure 6C is transferred to the secondary side of the P/T and converted into a recording current $I_r$, when the transistor $Q_a$ is turned on by the base current $I_{br}$. A predetermined collector current $I_a'$ shown in Figure 6D is transferred to the secondary side of the P/T and converted into the recording current $I_r$, when the transistor $Q_a'$ is turned on by the base current $I_{br}'$. The recording current $I_r$ is supplied to a head H'D through the R/T and thus a head current $I_h$ shown in Figure 6E flows through the head H'D. Here, switches for a recording/reproducing head are used as recording/reproducing switches REC/PB SW and REC/PB SW'.

On the other hand, as compared with the recording amplifier of Figure 4, the recording amplifier of Figure 5 has resistors $R_L$ and $R_L'$ as collector loads connected to the push-pull amplifiers $Q_a$ and $Q_a'$, respectively, thus omitting the P/T.

Recording equalization of the B-class push-pull recording amplifier will be described in more detail, with reference to Figure 4.

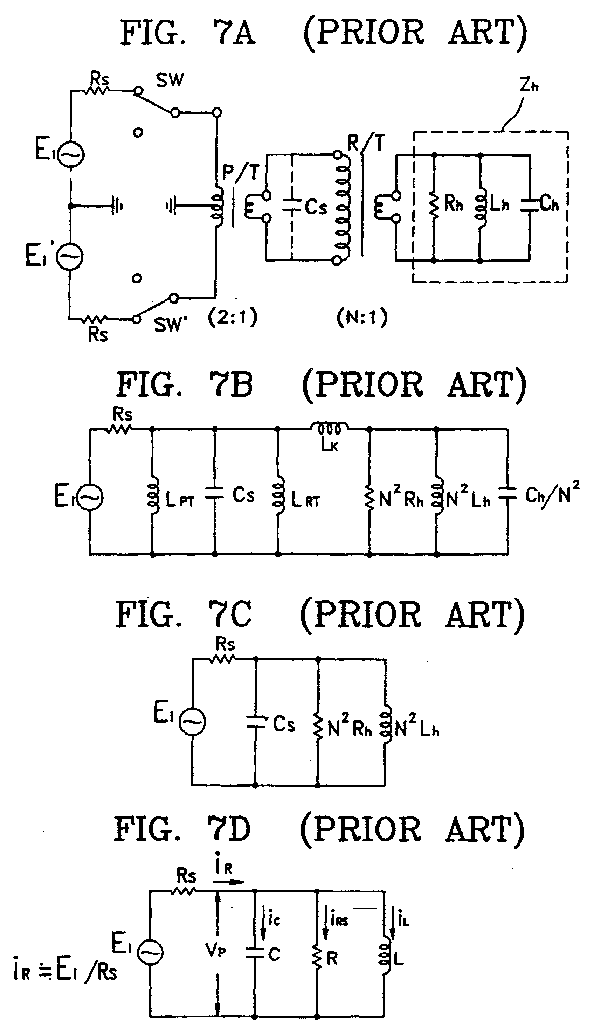

An equivalent circuit of the recording amplifier shown in Figure 4 is illustrated in Figure 7A. Referring to Figure 7A, when a head impedance $Z_h$ is measured in a small signal, the recording amplifier of Figure 4 can be approximated to the equivalent circuit of Figure 7A by connecting in parallel an equivalent loss resistor $R_h$, an inductor $L_h$ and a parasitic capacitor $C_h$, which are surrounded by a dotted block. The same equivalent circuit can be obtained in the case where a large current such as a recording current flows.

A current supplied through respective source output resistors $R_s$ by means of the input binary coded signal $E_i$ and its polarity-reverted signal $E_i'$, switched in the switches SW and SW', passes through the P/T and R/T, and reaches the magnetic head.

Here, the coupling coefficient of the P/T is nearly 1.00, and that of the R/T is about 0.94-0.98. Thus, the leakage inductance of the P/T is negligible. On the assumption that the leakage inductance of the R/T is $L_K$, inductances at the primary sides of the P/T and R/T are $L_{PT}$ and $L_{RT}$, respectively, a stray capacitance existing in an actual circuit is $C_s$ and the ratio of the number of turns of the stator (the primary side) and the rotator (the secondary side) of the R/T is N, the equivalent circuit of Figure 7A can be simplified to a circuit of Figure 7B.

The equivalent circuit of Figure 7B can be further simplified to a circuit shown in Figure 7C by a primary approximation based on practical conditions such that $L_{RT} \rangle N^2 L_h$, $C_s \gg C_h/N^2$, $L_{PT} \rangle N^2 L_h$, and $L_K \langle N^2 L_h$.

A head exciting current $i_L$ flowing in the head inductor $L_h$ for producing a recording magnetic field can be obtained in a circuit of Figure 7D which is equivalent to the circuit of Figure 7C by substituting $C_s$, $N^2 L_h$, and $N^2 R_h$ for C, L, and R, respectively. A recording current $i_R$ can be approximated to $E_i/R_s$, as described above.

A current $i_C$ flowing through a total stray capacitor C at the primary side of the R/T is initially determined, and then a current $i_{RS}$ flowing through a loss resistor R of the magnetic head and a current $i_L$ flowing through an inductor L of the magnetic head are calculated.

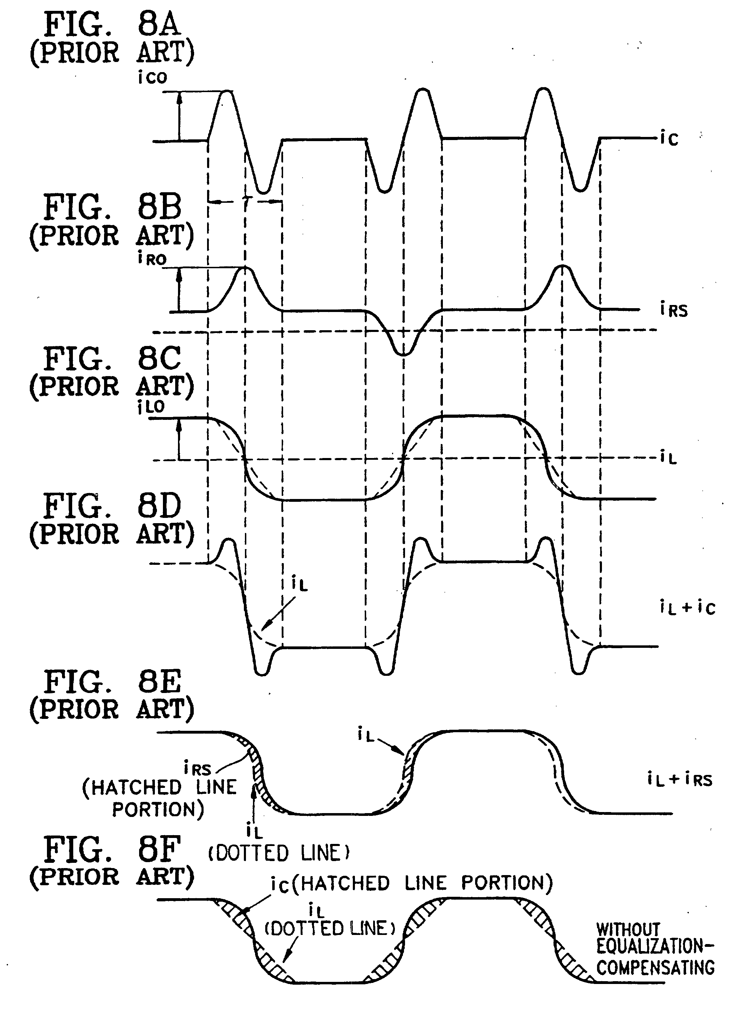

As shown in Figure 8A, a period $\tau$ of the $i_c$ waveform is defined as one cycle of a sine wave, and a voltage $V_p$ applied to the capacitor C is calculated by using the cycle $\tau$.

$$i_C = i_{CO} \cdot \sin(2\pi t/\tau) = C \cdot dV_p/dt \qquad (6)$$

where $i_{CO}$ is a maximum value of $i_C$ and

$$\tau = 2\pi \sqrt{(LC)} \qquad (7)$$

The current $i_{RS}$ of Figure 8B flowing through the resistor R can be calculated by

$$i_{RS} = V_p/R = (i_C \cdot dt)/CR \qquad (8)$$

The ratio of the maximum value $i_{RO}$ of the current $i_{RS}$ shown in Figure 8B to the maximum value $i_{CO}$ of the current $i_C$ shown in Figure 8A is given by

$$i_{RO}/i_{CO} = \tau/\pi CR \qquad (9)$$

The waveform of the current $i_L$ flowing through the inductor L is illustrated in Figure 8C, and

$$V_p = -L \cdot di_L/dt,$$

thus

$$i_L = -1/L \cdot V_p dt \qquad (10)$$

Therefore, to flow an intended current through the inductor L, it is necessary to supply both the current $i_C$ and the current $i_{RS}$ as the recording current $i_R$. Accordingly,

$$i_R = i_L + i_C + i_{RS} \qquad (11)$$

The ratio of the maximum value $i_{LO}$ of the current $i_L$ shown in Figure 8C to the maximum value $i_{CO}$ of the current $i_C$ is expressed as

$$i_{LO}/i_{CO} = \tau^2/(2\pi LC) \qquad (12)$$

On the other hand, a stray parasitic capacitance on the recording/reproducing switches REC/PB SW and REC/PB SW' or on collector distributing capacitors $C_{SO}$ and $C_{SO}'$ exists in the recording amplifier of Figure 4. If the switches SW and SW' are semiconductor devices, there exists an additional 10pF of stray capacitance, and the parasitic capacitance of a drum assembly is 10pF or above, including those of the R/T and a flat cable. However, the stray capacitance $C_S$ is generally considered to be approximately 20pF, in total . The sum $(i_L+i_C)$ of the currents $i_L$ and $i_C$ is illustrated in Figure 8D.

Therefore, as the stray capacitance becomes larger, the rise characteristics (average rise time and $\tau$) of the head magnetizing current $i_L$ are degraded, as noted from equation (7). A dotted line in Figure 8C indicates the waveform of the head magnetizing current $i_L$ exhibiting the degraded rise characteristics.

To obtain $i_L$ having the rise characteristic as indicated by a solid line in Figure 8C, a charging and discharging current $i_c$ should be provided to a stray capacitor $C_s$, simultaneously. To achieve a current exhibiting a steeper rise characteristic curve shown in Figure 8D, it is necessary to improve the rise characteristic of the input voltage signal $E_i$ in the recording amplifier.

Also, to improve the rise characteristic of $i_L$, the sum current $(i_L+i_{RS})$ showing a steeper rise characteristic curve than that of $i_L$ should be supplied as a head magnetizing current. The dose of the current $(i_L+i_{RS})$ is smaller than that of $i_L$ compensated for by $i_C$, i.e., a current $(i_L+i_C)$ shown in Figure 8D. The waveform of the sum current is illustrated in Figure 8E.

Therefore, to reduce the rise time of the head magnetizing current $i_L$ flowing through the inductor L, apertures of an input pulse should be corrected. Since recording equalization is possible by generating an input signal of the waveform shown in Figure 8D in an extra recording equalizer and providing the signal to the recording amplifier, a bit error rate can be improved during playback of a digital signal. Thus, a recording equalization for reducing the rise time of the head current is required for a high-speed, and high-density recording.

Without this recording equalization, a part of the rising portion of the head magnetizing current $i_L$ is lost due to charge and discharge of the stray capacitance $C_s$, thus being ineffective in magnetizing. As a result, the rise time is increased and the rise characteristic of the current $i_L$ for magnetizing the magnetic tape is lowered, leading to degradation of a high-speed, and high-density recording performance.

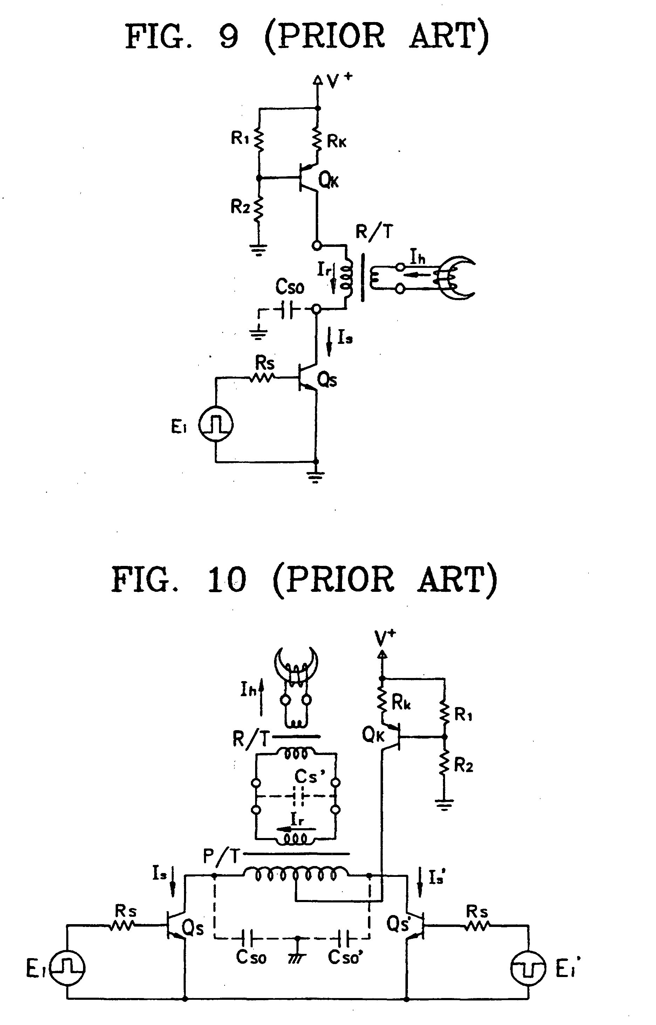

Figures 9 and 10 illustrate recording amplifiers of a switching type, adopting constant current sources. Figure 9 shows a single-ended recording amplifier and Figure 10 shows a push-pull recording amplifier.

A transistor $Q_k$ in the single-ended recording amplifier of Figure 9 has a current feedback resistor $R_k$ connected to the emitter thereof and thus controls a recording current $I_r$ to be constant. A transistor $Q_s$ functions as a switch for supplying or blocking the recording current $I_r$ according to an input binary coded pulse signal $E_i$.

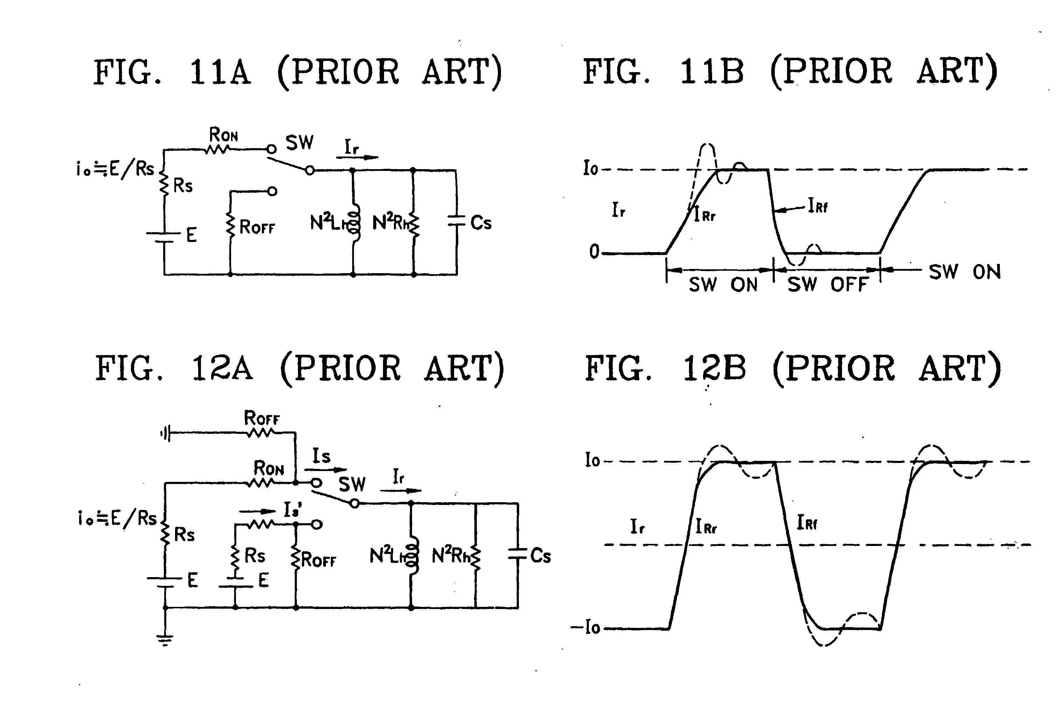

If a resistance for the turned-on transistor $Q_s$ is $R_{ON}$, a resistance for the turned-off transistor $Q_s$ is $R_{OFF}$, and a constant current output impedance is $R_S$, an equivalent circuit of the recording amplifier shown in Figure 9 can be obtained as shown in Figure 11, and the following condition is satisfied in an actual circuit.

$$R_{ON} \ll R_S \ll R_{OFF} \tag{13}$$

Meanwhile, the waveform of a recording current $I_r$ is illustrated in Figure 11B.

In Figure 11B, a rise time constant $\tau_r$ and a rising current $I_{Rr}$ of $I_r$ are given by

$$\tau_r = N^2 L_h / R_S \tag{14}$$

$(R_S \ll R_{ON})$

$$I_{Rr} = I_O \{1 - \exp(-t/\tau_r)\} \tag{15}$$

where $I_O \simeq E/R_S$.

$I_{Rr}$ at the start of rising $(t \langle \tau_r)$ is given as

$$I_R = \frac{E}{R_S} \quad \{1 - [1 - (R_s \cdot t)/N^2 L_h + (R_s \cdot t/(N^2 L_h)^2/2 - ...]\}$$

$$= \frac{E}{(N^2 L_h)} \cdot t\{1 - (R_s/(N^2 L_h))/2 \cdot t + ....\}$$

Similarly, a fall time constant $I_f$ and a falling current $I_{Rf}$ of $I_r$ are expressed as

$$\tau_f = N^2 L_h / R_{OFF} \tag{16}$$

$(R_{OFF} \ll N^2 R_h)$

$$I_{Rf} = I_o \{1 - \exp(-t/\tau_f)\} \tag{17}$$

$I_{Rf}$ at the start of falling $(t \langle \tau_f)$ is as follows:

$$I_{Rf} = E/(N^2 L_h) \cdot t\{1 - (R_{OFF}/(N^2 L_h))/2 \cdot t + ...\}$$

Here, ringings are produced by the stray capacitance $C_s$ and the head inductance $N^2 L_h$ in view of the collector capacitance $C_{SO}$ of the transistor $Q_s$ shown in Figure 9. The cycle $\tau_{rg}$ of these ringings is given in the following equation:

$$\tau_{rg} = N \sqrt{(L_h C_s)} \tag{18}$$

As noted in equation (18), the resistance $N^2 R_h$ has no significant impact on the rise characteristic of the recording current $I_r$.

Therefore, since there is a large disparity between the rise time and the fall time, as shown in the current waveform of Figure 11B, even-numbered high harmonics components are generated in the recording current, and the eye pattern of a reproduction signal is distorted, causing errors.

To prevent generation of these even-numbered high harmonics components, the push-pull recording amplifier of Figure 10 should be used. An equivalent circuit of the recording amplifier shown in Figure 10 is illustrated in Figure 12A and the waveform of the recording current $I_r$ flowing through the head is illustrated in Figure 12B.

As shown in Figure 12B, the rise and fall time constants of the recording current I, are equal and given by

$$\tau_r = \tau_f = N^2 L_h / R_S \tag{19}$$

Further, ringings of the total stray capacitance $C_s$ in view of the parasitic capacitance $C_s'$ between terminals of the P/T and the R/T and the collector capacities $C_{SO}$ and $C_{SO}'$ of the transistors $Q_s$ and $Q_s'$ of Figure 10 are generated to be vertically symmetrical as shown in Figure 12B.

To enable the head current $I_h$ and the recording current $I_r$ to rapidly rise, the head inductance $L_h$ of the time constants $\tau_r$ and $\tau_f$ of equation (19) should be small, or the output resistance $R_s$ of the constant current source should be large. The head inductance $L_h$ is related with signal reproducing characteristics and, generally, an optimum value is given as the head inductance $L_h$ in terms of a highly efficient playback.

If the output resistance $R_S$ of the constant current source is large, a ringing generation voltage becomes larger and a ringing attenuation becomes smaller, due to the stray capacitance $C_s$. That is, the larger $R_s$ becomes, the smaller the amplitude of a ringing and the larger the frequency of the ringing. Thus, $R_S$ is limited to hundreds of ohms. If $R_S$ is $200\Omega$ and the inductance $N^2 L_h$ at the primary of the R/T is $10\mu H$, $\tau_r = \tau_f = 50ns$, not enough for a high-speed recording.

As described above, the prior art recording amplifiers described in connection with Figures 1-12 have the following drawbacks.

The A-class recording amplifier of Figure 1 performs a recording equalization by using a recording equalizer for the input voltage signal $E_i$ received by the transistor $Q_a$ having a constant current control function. Thus, degradation of recording characteristics caused by the parasitic stray capacitance $C_s$ on a recording system can be compensated for, while to operate the linear amplifier, power dissipation is large, and a power transistor is required, entailing the need for a high power voltage. As a result, the recording amplifier can not be compact.

The recording amplifiers of Figures 4 and 5 also exhibit the problems of high power dissipation, the need for a power transistor, and inapplicability to a small power-consuming recording.

Therefore, the A- and B-class recording amplifiers can perform recording equalization yet require a linear amplifying function, consuming much power. They cannot satisfy the demands of small size and low-power consumption.

The recording amplifiers of a constant current switching type shown in Figures 9 and 10 need a constant current source transistor, not the switching transistors $Q_s$ and $Q_s'$, as a power transistor. Thus, the recording amplifiers can be small and low power-consuming. However, the input of a recording-equalized voltage signal to the switching transistors $Q_s$ and $Q_s'$ simply turns the circuits on and off, thus making recording equalization-induced improvement impossible. Further, to reduce the rise time of a recording current, a large band and a high impedance are required as the output characteristics of the constant current source transistor $Q_k$.

US 5 333 081 describes a magnetic head driving circuit comprising delay circuits. A time delay in an inverting action generated by the delay circuits allows the switching time of a magnetic head current to be shortened. This magnetic head driving circuit offers protection to switching transistors from reverse bias voltages caused by unmatched switching signals. This prior art is reflected by the preambles of claims 1 and 14.

Accordingly, with a view to overcoming or reducing the above problems, it is an aim of preferred embodiments of the invention to provide a magnetic recording device employing a recording amplifier for a high-speed, and high-density recording in which the rise characteristics of a recording current can be improved without an extra recording equalizer.

It is another aim of preferred embodiments of the present invention to provide a magnetic recording device employing a recording amplifier for a high-speed, and high-density recording, which is small and low power-consuming.

It is still another aim of embodiments of the present invention to provide a magnetic recording device employing a recording amplifier in which a recording current having a constant instantaneous value flows, and a transient pulse current is generated during reversal of the polarity of the recording current to a magnetic head.

It is a further aim to provide a magnetic recording device which records a digital signal by a transient pulse current generated during reversal of the polarity of a recording current.

It is yet another aim to provide a magnetic recording device which records a digital signal by providing a recording current having a predetermined instantaneous value, and generating a transient pulse current during reversal of the polarity of the recording current to a magnetic head.

According to a first aspect of the present invention, there is provided a magnetic recording device for recording a digital signal by providing a recording current indicative of digital information to a magnetic head, comprising: a shaping driver for positive and negative signals whose polarities are reversed, corresponding to said digital information; push-pull means for generating a recording current corresponding to said positive and negative signals and generating a transient pulse current during reversal of the polarity of said recording current; and current switching means for switching a current flowing through said push-pull means in response to said positive and negative signals, characterised in that: said digital signal is recorded on said magnetic recording medium on the basis of said transient pulse current, whereby the switching speed of the recording current is increased by using this transient pulse current.

Preferably, constant current controlling means are provided for controlling entire current signals provided to said push-pull means to be constant.

Means for generating a compensation signal against a variation in the instantaneous value of a recording current generated in said push-pull means, and constant current controlling means for controlling said instantaneous value of said recording current to be constant in response to said compensation signal are preferably provided.

Preferably, the magnetic recording device according to the first aspect of the present invention comprises: a pair of switches for switching positive and negative current signals; a first amplifying device for generating a recording current corresponding to a current signal switched by one of said pair of switches and generating a transient pulse current during reversal of the polarity of said recording current to said magnetic head; a second amplifying device for generating a recording current corresponding to a current signal switched by the other switch and generating a transient pulse current during reversal of the polarity of said recording current to said magnetic head; and a constant current controlling device for controlling a constant current flowing through said first and second amplifying devices.

Preferably, the magnetic recording device according to the first aspect of the invention for recording a digital signal by providing a recording current corresponding to digital information via a rotary transformer to a magnetic head and magnetizing a magnetic recording medium, comprises: a pair of switches for switching positive and negative current signals; a first amplifying device for generating a recording current corresponding to a current signal switched by one of said pair of switches and generating a transient pulse current during reversal of the polarity of said recording current to said magnetic head; a second amplifying device for generating a recording current corresponding to a current signal switched by the other switch and generating a transient pulse current during reversal of the polarity of said recording current to said magnetic head; a compensation signal generator for generating a compensation signal in the form of a voltage signal according to a variation of the instantaneous value of a recording current generated, caused by passage via said rotary transformer; and a constant current controlling device for controlling said instantaneous value of said recording current to be constant in response to said compensation signal, wherein said transient pulse current flows through said magnetic head and a digital signal is recorded on said magnetic recording medium.

Preferably, the magnetic recording device further comprises: a first damper device having one end inserted between one of said pair of switches and said first amplifying device, and the other end connected to a power source; and a second damper device having one end inserted between the other switch and said second amplifying device, and the other end connected to said power source, wherein said transient current rapidly converges into a normal current value by means of said first and second damper devices.

Preferably, the magnetic recording device according to the first aspect of the invention comprises: a first complementary semiconductor device for generating a recording current corresponding to said positive signal and generating a transient pulse current during reversal of the polarity of said recording current to said magnetic head; a second complementary semiconductor device connected in parallel to said first complementary semiconductor device, for generating a transient pulse current during reversal of the polarity of said recording current to said magnetic head; and a constant current controlling device commonly connected to said first and second complementary semiconductor devices.

Preferably, the magnetic recording device further comprises: a compensation signal generator for generating a compensation signal in the form of a voltage signal according to a variation of the instantaneous value of a recording current generated, caused by passage via a rotary transformer.

Preferably, the magnetic recording device further comprises: a first damper device having one end connected to said first complementary semiconductor device, and the other end connected to a power source; and a second damper device having one end connected to said second complementary semiconductor device, and the other end connected to said power source, wherein said transient current rapidly converges into a normal current value by means of said first and second damper devices.

Preferably, the magnetic recording device according to the first aspect of the invention for recording a digital signal by providing a recording current corresponding to digital information to a magnetic head and reproducing said recorded digital signal, comprises: first and second DC voltage supply terminals for receiving predetermined first and second DC voltages; a first pnp transistor having a base connected to said shaping driver and an emitter connected to said first DC voltage supply terminal, for activating according to said negative signal; a second pnp transistor having a base connected to said shaping driver and an emitter connected to said first DC voltage supply terminal, for activating according to said positive signal; a first npn transistor having a base connected to said shaping driver and a collector connected to the collector of said first pnp transistor, for generating a rising pulse current at the moment when said first pnp transistor is off and providing said rising pulse current as a recording current to said magnetic head; a second npn transistor having a base connected to said shaping driver and a collector connected to the collector of said second pnp transistor, for generating a rising pulse current at the moment when said second pnp transistor is off and providing said rising pulse current as a recording current to said magnetic head; and a third npn transistor having a base connected to said first DC voltage supply terminal, a collector connected commonly to the emitters of said first and second npn transistors, an emitter connected to a variable resistor for controlling a current which is connected to said second DC voltage supply terminal.

Preferably, the magnetic recording device further comprises: a comparator connected to the collectors of said first and second npn transistors, for comparing a predetermined reference value with an instantaneous value of a recording current changed due to the passage of said recording current via a rotary transformer; and an integrator for integrating the output of said comparator and generating a compensation signal.

Preferably, a transient pulse current is generated to have rise characteristics rapidly improved by adjusting the magnitudes of said first and second DC voltages, turning off said first to third npn transistors during switching the polarity of said recording current, and applying a voltage corresponding to the entire power source to a magnetic head.

Preferably, the magnetic recording device further comprises: a first damper device having one end connected to the common collector of said first pnp transistor and said first npn transistor, and the other end connected to said first DC voltage supply terminal; and a second damper device having one end connected to the common collector of said second pnp transistor and said second npn transistor, and the other end connected to said first DC voltage supply terminal, wherein a rising pulse current rapidly converges into a normal current value by means of said first and second damper devices.

According to a second aspect of the present invention there is provided a magnetic recording method for recording a digital signal on a magnetic recording medium by a recording current indicative of digital information provided to a magnetic head, said method comprising the steps of: generating positive and negative signals whose polarities are reversed, corresponding to said digital information; and generating a recording current corresponding to said positive and negative signals, generating a transient pulse current during switching the polarity of said recording current, and providing said transient pulse current to said magnetic head, characterised in that: said digital signal is recorded on said magnetic recording medium on the basis of said transient pulse current, whereby the switching speed of the recording current is increased by using this transient pulse current.

The method may further comprise the steps of:

generating a compensation signal against a variation in the instantaneous value of said recording current; and controlling the instantaneous value of said recording current to be constant in response to said compensation signal.

For a better understanding of the invention, and to show how embodiments of the same may be carried into effect, reference will now be made, by way of example, to the accompanying diagrammatic drawings, in which:

Figure 1 illustrates a conventional A-class recording amplifier;

Figures 2A-2D illustrate the waveforms of a voltage and a current of each portion of the recording amplifier shown in Figure 1;

Figure 3 is an equivalent circuit diagram of the recording amplifier shown in Figure 1;

Figures 4 and 5 illustrate examples of a conventional B-class recording amplifier;

Figures 6A-6E illustrate the waveforms of a voltage and a current of each portion of the recording amplifier shown in Figure 4;

Figures 7A-7D are equivalent circuit diagrams of the recording amplifier shown in Figure 4;

Figures 8A-8F illustrate the waveforms of a voltage and a current of each portion of the equivalent circuit shown in Figure 7D;

Figures 9 and 10 illustrate examples of a conventional recording amplifier of a switching type, for controlling a constant current;

Figures 11A and 11B illustrate an equivalent circuit of the recording amplifier shown in Figure 9 and the waveforms of a head current;

Figures 12A and 12B illustrate an equivalent circuit of the recording amplifier shown in Figure 10 and the waveforms of a head current;

Figure 13 is a schematic block diagram of a digital magnetic recording device applied to an embodiment of the present invention;

Figure 14 is a detailed block diagram of an embodiment of the recording amplifier shown in Figure 13;

Figure 15 is a diagram of the recording amplifier shown in Figure 14, for explaining the principle thereof;

Figures 16A-16G illustrate the waveforms of a voltage and a current of each portion of the recording amplifier shown in Figure 15;

Figure 17 is a detailed circuit diagram of the recording amplifier shown in Figure 15;

Figures 18A-18c illustrate the waveforms of an input voltage signal and a head current supplied to the recording amplifier shown in Figure 17;

Figure 19A is a circuit diagram of a flyback recording amplifier prior to switching for current polarity reversal;

Figure 19B illustrates the initial values of a voltage and a current in each portion under t=0;

Figures 20a and 20B are diagrams for explaining a load impedance of a head portion and an equivalent circuit;

Figure 21A is a circuit diagram for explaining a transient phenomenon prior to switching for current polarity reversal in the flyback recording amplifier;

Figure 21B illustrates the waveforms of a voltage and a current for Figure 21A;

Figure 22A is a circuit diagram for explaining a transient phenomenon after switching for current polarity reversal in the flyback recording amplifier;

Figure 22B illustrates the waveforms of a voltage and a current for Figure 22A;

Figure 23A is a circuit diagram showing variations in a voltage and a current of each circuit portion when a pair of dampers are provided to the circuit of Figure 22A;

Figure 23B illustrates the waveforms of a voltage and a current for Figure 23A;

Figures 24a-24C illustrate the waveforms of input and output of a recording amplifier loaded inside a rotational cylinder;

Figure 25 is an equivalent circuit diagram of a recording system for explaining variations in an instantaneous value of a recording current;

Figures 26A-26E are diagrams showing variations in the current of each portion in the circuit of Figure 25;

Figure 27 is a diagram showing variations in the sum of energies accumulated in the load impedance of the recording amplifier shown in Figure 25, in accordance with time passage;

Figures 28A-28C illustrate variations in the amplitude of a flyback pulse corresponding to an input bit length;

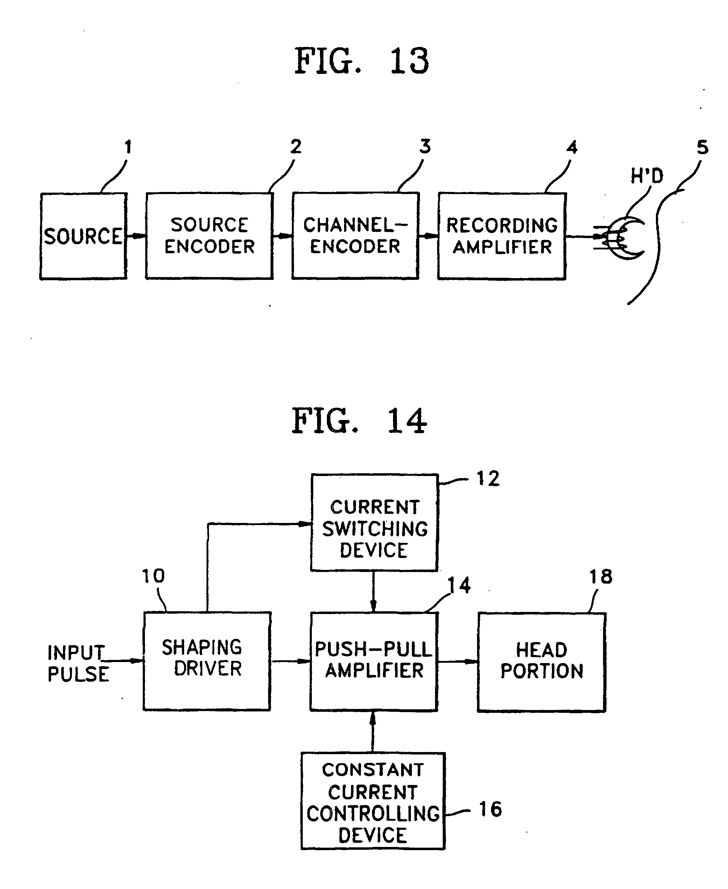

FIG, 29 is a block diagram of another embodiment of the recording amplifier shown in Figure 13;

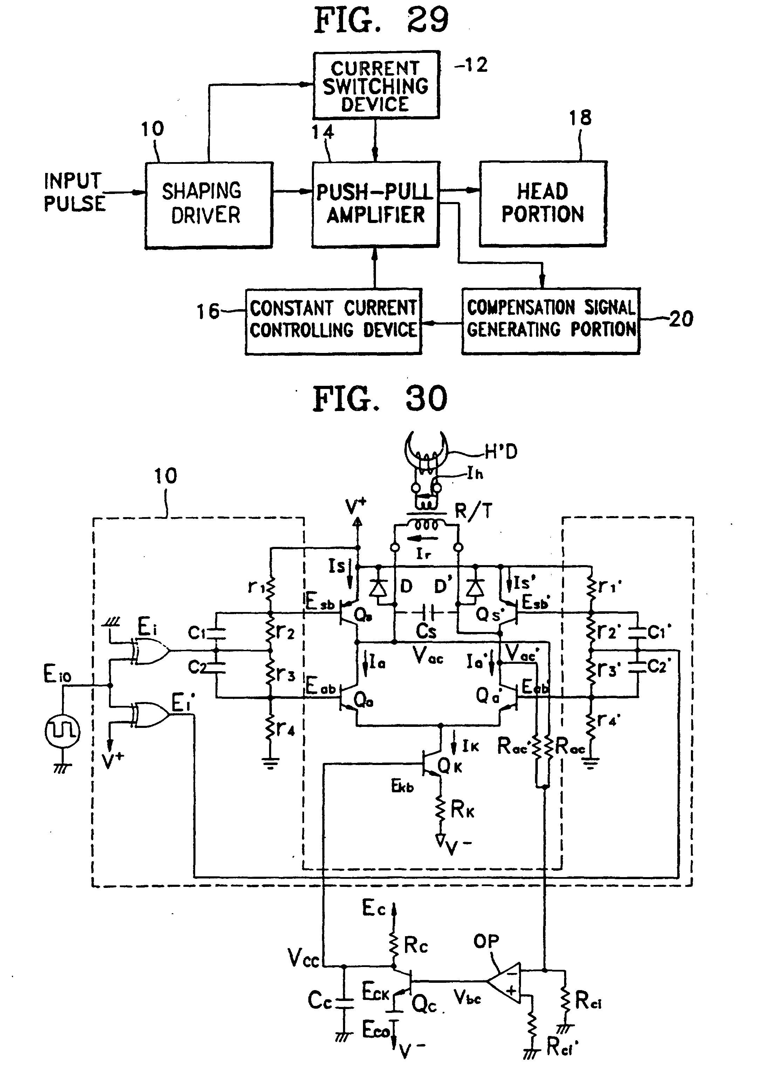

Figure 30 is a detailed circuit diagram of the recording amplifier shown in Figure 29;

Figures 31A-31E illustrate the waveforms of input and output signals of the compensation signal generating portion shown in Figure 29; and

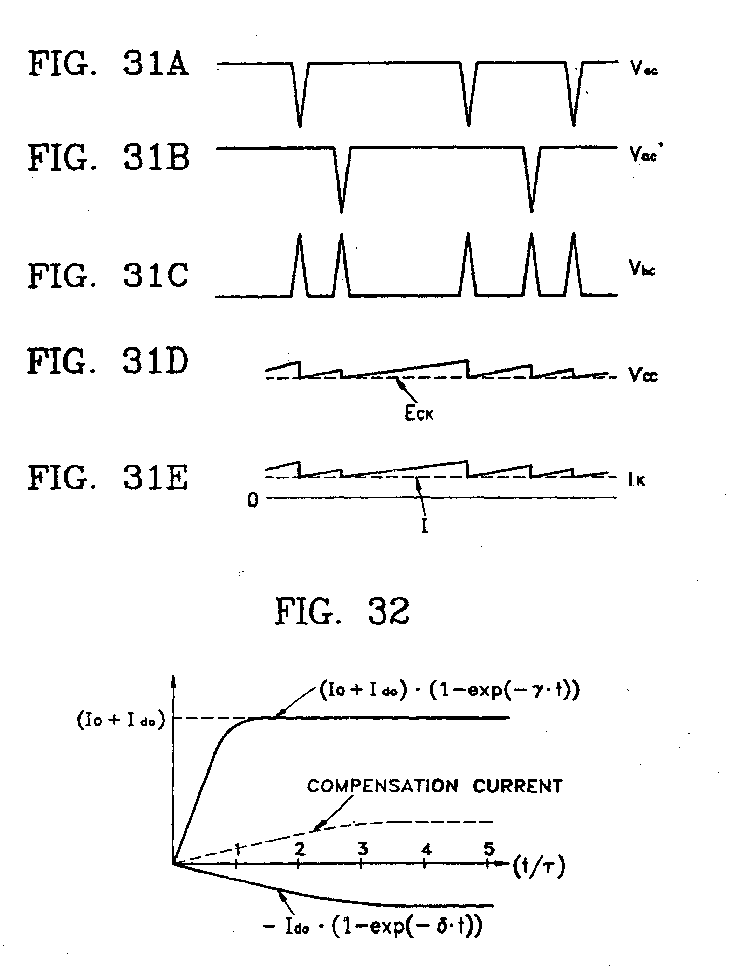

Figure 32 illustrates the calculated value of a compensation current added to stabilize the switching characteristics of a recording current.

Preferred embodiments of a magnetic recording device according to the present invention will be described, referring to the attached drawings.

Figure 13 is a schematic block diagram of a digital magnetic recording device according to an embodiment of the present invention.

Referring to Figure 13, digital video and/or audio signals are output from a signal source 1. The source data is compressed in a source encoder 2 to remove the redundancy of the source data. A channel encoder 3 channel-encodes the compressed data to add the redundancy to the data unlike the source encoding and thus increase the robustness of a system against errors generated in a channel. This channel-encoding is referred to as modulation. A recording amplifier 4 converts the channel-encoded data into its corresponding current signal and provides a transient pulse signal having improved rise characteristics to a head H'D, to thereby magnetize a recording medium 5 and record the digital information.

Figure 14 is a block diagram of a recording amplifier of a flyback switching type suggested in the present invention, according to an embodiment of the recording amplifier shown in Figure 13.

In Figure 14, the recording amplifier includes a shaping driver 10 for providing positive and negative signals corresponding to input pulses, a current switching device 12 for switching a recording current flowing through a push-pull amplifier 14, corresponding to the positive and negative signals output from the shaping driver 10, the push-pull amplifier 14 for receiving the positive and negative signals from the shaping driver 10 and supplying a reversed signal whose rise characteristics are improved at the moment when the polarity of the recording current is reversed, that is, a transient pulse current, to a head portion 18, thereby increasing recording efficiency, and a constant current controlling device 16 for controlling a constant current to of the push-pull amplifier 14.

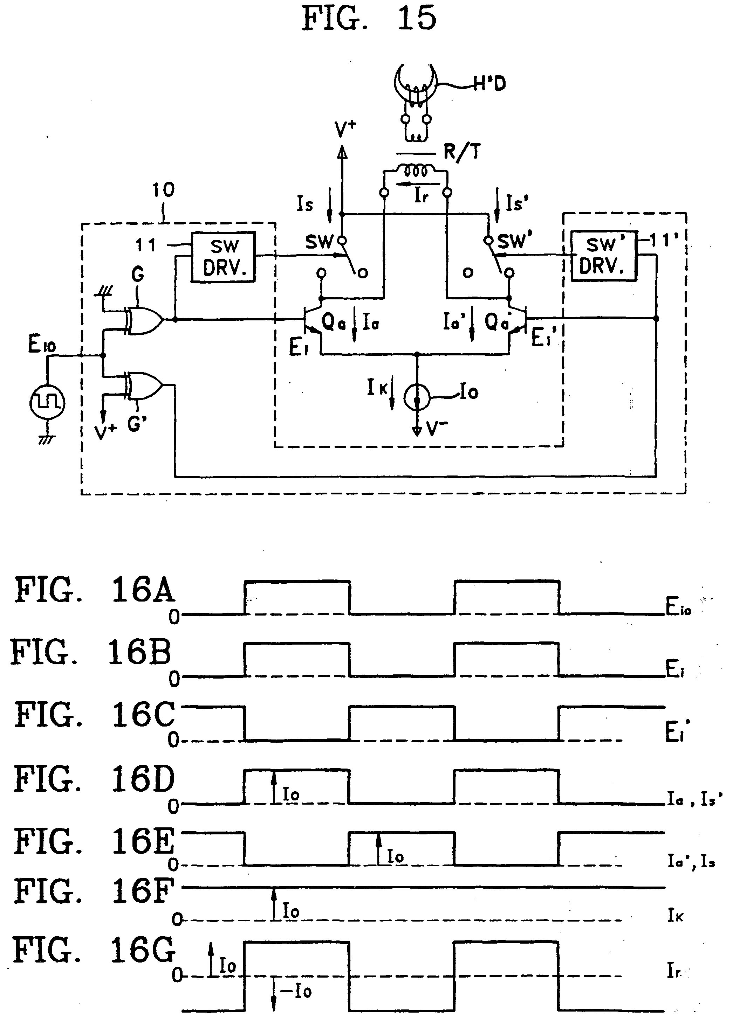

Figure 15 is a circuit diagram of the recording amplifier shown in Figure 14, for explaining the principle thereof. In the circuit, the polarity of the recording current is reversed by flyback and the switching speed of the recording current is simultaneously increased by using a phenomenon similar to the latch-up phenomenon which causes problems in C-MOS circuits.

Here, using the phenomenon similar to latch-up means that the absolute values of power supply voltages applied to DC voltage supply terminals $V^+$ and $V^-$ are determined as a minimum value required to maintain the function of a recording amplifier and current rise characteristics. In embodiments of the present invention, a transient pulse current is generated when the recording current is reversed by properly adding this power supply voltage, and recording equalization is available by improving the rise characteristics of the transient pulse current, thereby enabling a high-density recording.

Referring to Figure 15, a pair of components, i.e., a current switch SW and an amplifying transistor $Q_a$ connected to the switch SW, are connected in parallel to another pair of components, i.e., a current switch SW' and an amplifying transistor $Q_a'$ connected to the switch SW', thus forming a bridge. In this bridge, a switch operates simultaneously with a transistor diagonal to the switch.

Fixed terminals of the pair of switches SW and SW' are commonly connected to the DC voltage supply terminal $V^+$.

The respective collectors of the pair of transistors $Q_a$ and $Q_a'$ are connected to both ends of a primary side of an R/T connected to a head H'D, and the emitters of the transistors $Q_a$ and $Q_a'$ are commonly connected to a DC voltage supply terminal $V^-$ via a constant current source $I_o$.

The shaping driver 10 for generating a positive voltage signal Ei and a negative voltage signal $E_i'$ includes an exclusive OR gate G, an exclusive OR gate G', a switch driver 11 connected to an output port of the exclusive OR gate G, for controlling the switch SW, and a switch driver 11' connected to an output port of the exclusive OR gate G' , for controlling the switch SW' . One input port of the exclusive OR gate G is grounded, the other input port thereof receives a driving pulse $E_{io}$, and the output port thereof is connected to the base of the transistor $Q_a$. One input port of the exclusive OR gate G' is connected to the DC voltage supply terminal $V^+$, the other input port thereof receives the driving pulse $E_{io}$, and the output port thereof is connected to the base of the transistor $Q_a'$.

One end of the constant current source $I_o$ is connected to the common emitter of the pair of transistors $Q_a$ and $Q_a'$, and the other end thereof is connected to the DC voltage supply terminal $V^-$.

Here, the exclusive OR gates G and G', and the switch drivers 11 and 11' correspond to the shaping driver 10, the pair of transistors $Q_a$ and $Q_a'$ correspond to the push-pull amplifier 14, the constant current source $I_o$ corresponds to the constant current controlling device 16, the head H'D and the R/T correspond to the head portion 18.

The operation of the recording amplifier will be described in connection with Figure 15.

In Figure 15, the shaping driver 10 surrounded by a dotted line receives the driving pulse $E_{io}$, and outputs the positive voltage signal $E_i$ and the negative voltage signal $E_i'$ via the exclusive OR gates G and G', respectively. The positive voltage signal $E_i$ is applied to the base of the transistor $Q_a$ and a collector current $I_a$ flows through the transistor

$Q_a$. The negative voltage signal $E_i'$ is applied to the base of the transistor $Q_a'$ and a collector current $I_a'$ flows through the transistor $Q_a'$.

Simultaneously, the positive voltage signal $E_i$ and the negative voltage signal $E_i'$ output from the exclusive OR gates G and G' operate the current switches SW and SW' and control currents $I_s$ and $I_s'$ flowing through the switches SW and SW', respectively. A common emitter current $I_k$ of the transistors $Q_a$ and $Q_a'$ is the sum of the collector currents $I_a$ and $I_a'$.

Since the common emitter of the transistors $Q_a$ and $Q_a'$ is connected to the DC voltage supply terminal V⁻ via the constant current source $I_o$, the peak-to-peak value of a recording current $I_r$ flowing through the primary side of the R/T is $2 \times I_o$.

On the assumption that the current switches SW and SW' and the transistors $Q_a$ and $Q_a'$ perform a desirable switching operation, and a transient period when a current is switched is neglected, the waveforms of a current and a voltage in each portion of the recording ampifier are illustrated in Figures 16A-16G.

Figure 16a illustrates the waveform of the driving pulse $E_{io}$, Figure 16B illustrates the waveform of the positive voltage signal $E_i$, Figure 16C illustrates the waveform of the negative voltage signal $E_i'$, Figure 16D illustrates the waveforms of the current $I_s'$ flowing in the current switch SW' and the current $I_a$ flowing in the transistor $Q_a$, Figure 16E illustrates the waveforms of the current $I_s$ flowing in the current switch SW and the current $I_a'$ flowing in the transistor $Q_a'$, Figure 16F illustrates the common emitter current $I_k$ of the transistors $Q_a$ and $Q_a'$, and Figure 16G illustrates the recording current I, flowing through the R/T.

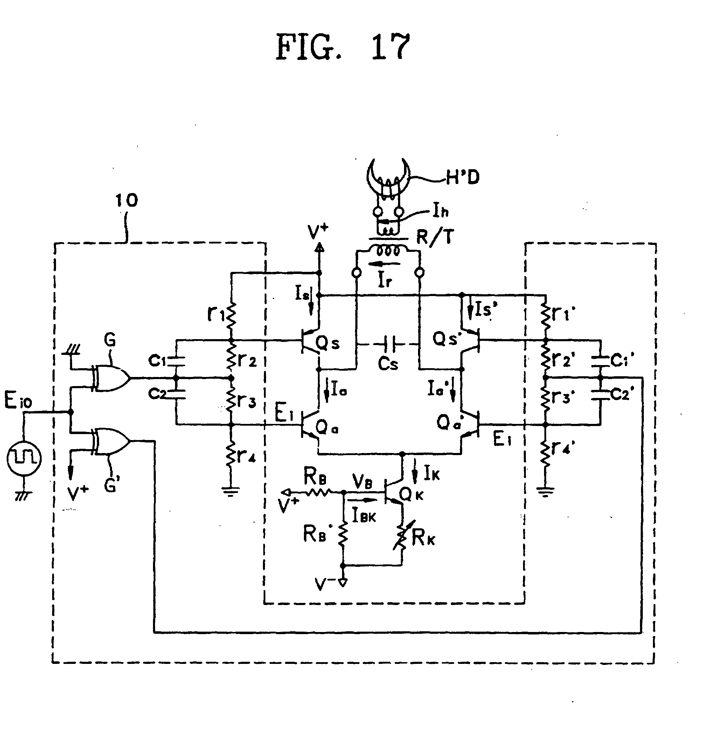

Figure 17 illustrates a circuit in which the current switches SW and SW' of Figure 15 are replaced with transistors $Q_s$ and $Q_s'$. In the circuit, the transistors $Q_s$ and $Q_s'$ and the transistors $Q_a$ and $Q_a'$ are simultaneously driven by a high-speed logic circuit for a general purpose.

In Figure 17, an npn transistor is used as the amplifying transistor $Q_a$ of FIG, 15, a pnp transistor $Q_s$ complementary to the transistor $Q_a$ serves as the current switch SW, and the transistors $Q_a$ and $Q_s$ are simultaneously driven by the voltage signal $E_i$. A current switching transistor $Q_s'$ and the amplifying transistor $Q_a'$ being counterparts of the transistors $Q_s$ and $Q_a$, respectively, are simultaneously controlled by the voltage signal $E_i'$ having a polarity opposite to that of $E_i$.

The transistor $Q_a$ is complementary to the transistor $Q_s$, while the transistors $Q_a'$ is complementary to the transistor $Q_s'$.

An end of a resistor $r_2$ serially connected to a resistor $r_1$ having one end connected to the DC voltage supply terminal V⁺, and an end of a peaking capacitor $C_1$ connected to the resistor $r_2$ in parallel are commonly connected to the base of the transistor $Q_a$, while the other ends of the resistor $r_2$ and the peaking capacitor $C_2$ are connected to the output port of the exclusive OR gate G.

An end of a resistor $r_3$ serially connected to a resistor $r_4$ having a grounded end, and an end of a peaking capacitor $C_2$ connected to the resistor $r_3$ in parallel are connected to the base of the transistor $Q_a$, while the other ends of the resistor $r_3$ and the peaking capacitor $C_2$ are connected to the output port of the exclusive OR gate G.

Resistors $r_1'$-$r_3'$ and peaking capacitors $C_1'$ and $C_2'$ connected to the bases of the transistors $Q_s'$ and $Q_a'$ are arranged symmetrically with the resistors $r_1$-$r_3$ and the peaking capacitors $C_1$ and $C_2$.

On the other hand, the constant current controlling device 16 has a current feedback npn transistor $Q_K$. The collector of the transistor $Q_K$ is connected to the common emitter of the pair of transistors $Q_a$ and $Q_a'$, the emitter thereof is connected to the DC voltage supply terminal V via the current feedback resistor $R_K$, and the base thereof is connected to the DC voltage supply terminal V⁺. The ends of resistors $R_B$ and $R_B'$ for controlling a base current $I_{BK}$ are commonly connected to the base of the transistor $Q_K$, and the other ends thereof are connected to the DC voltage supply terminals V⁺ and V⁻, respectively.

The base current $IB_K$ of a predetermined value is injected to the base of the npn transistor $Q_K$ for controlling a constant current and, to effect a full constant current control, the current feedback resistor $R_K$ is connected to the emitter of the constant current controlling transistor $Q_K$ and a resistance feedback is performed. The collector current $I_K$ of the transistor $Q_K$ can be controlled by varying the value of the resistor $R_K$. Thus, the saturation of the collector currents of the transistors $Q_a$ and $Q_a'$ can be controlled at predetermined values, since the common emitter of the amplifying transistors $Q_a$ and $Q_a'$ are connected to the collector of the constant current controlling transistor $Q_K$.

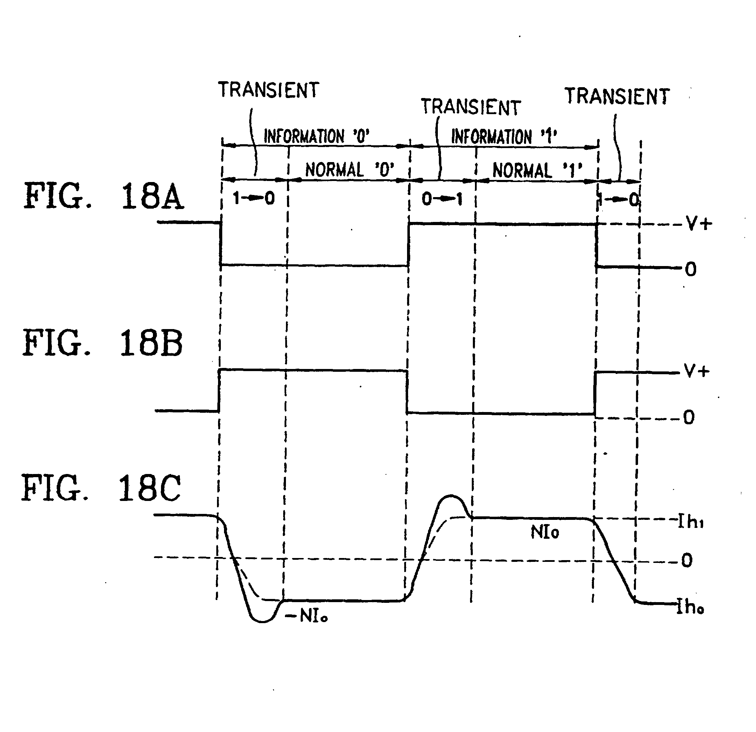

In practice, a problem arises from a transient period when a current polarity is reversed in the circuit for supplying the recording current to the magnetic head, as shown in Figures 18A-18C. A shorter transient period is better for a high-speed, and high-density recording.

Figure 18a illustrates the waveform of the signal $E_i$ supplied from the shaping driver according to digital information, Figure 18B illustrates the signal $E_i'$ having a polarity opposite to that of the signal $E_i$, and Figure 18C illustrates the waveform of the recording current $I_r$ corresponding to these signals $E_i$ and $E_i'$.

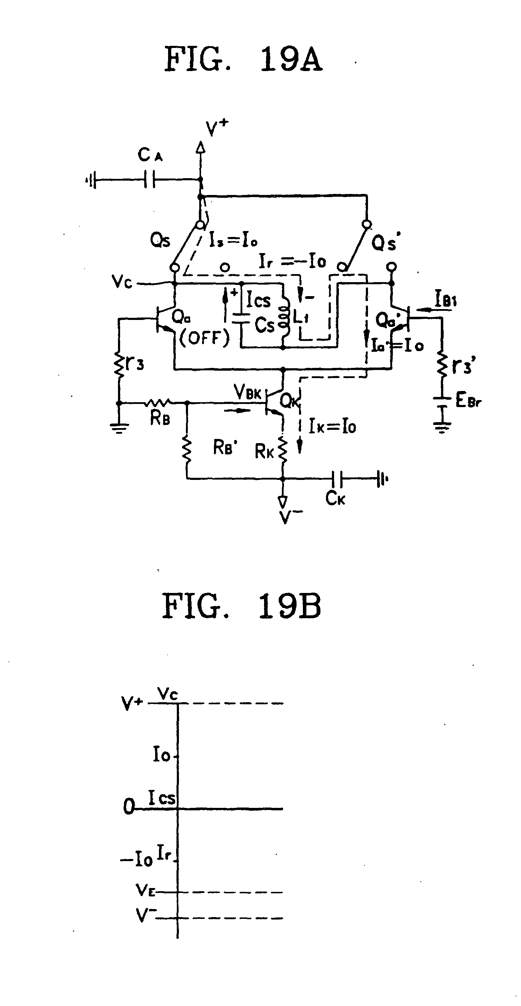

Figure 19A is a circuit diagram of the flyback recording amplifier, showing the initial values of a voltage and a current in each portion prior to switching for a current polarity reversal, and Figure 19B illustrates the initial conditions of a voltage and a current in each portion under an initial state of t=0. In Figure 19A, the transistors $Q_s$ and $Q_s'$ are

shown in the form of switches.

Under an initial condition of t ⟨ 0 shown in Figure 19A, $Q_s$=ON, $Q_s$'=OFF, $Q_a$=OFF, and $Q_a$'=ON. Thus, the current $I_o$ flows in the order of $V(+) \to Q_s(I_s) \to L_t(-I_r) \to Q_a'(I_a') \to Q_k(I_k) \to V(-)$ according to the definition of a current flowing each portion.

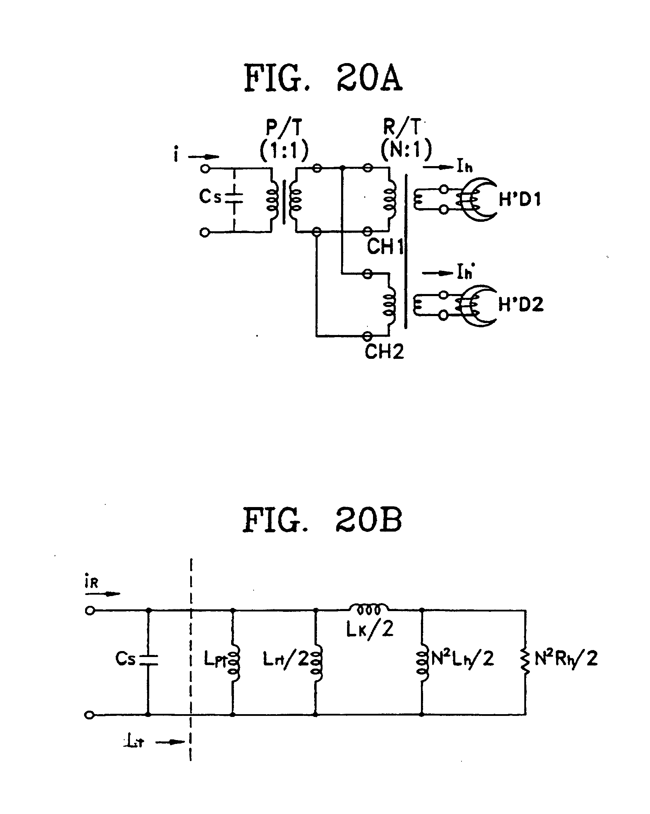

Here, $L_t$ is an inductance viewed from the primary side of the R/T toward the head, as shown in Figure 20B, and more correctly, a complex inductance since it includes a resistance component $N^2 R_h/2$.

Figure 20A illustrates an example of a head portion having one P/T, one R/T, a two-channel transmission path, and a recording/reproducing head for each channel. A variation can be made by omitting the P/T.

To reduce the rise time of a transient pulse signal generated during a transient period, it is necessary to consider inductances at the primary sides of the P/T and R/T.

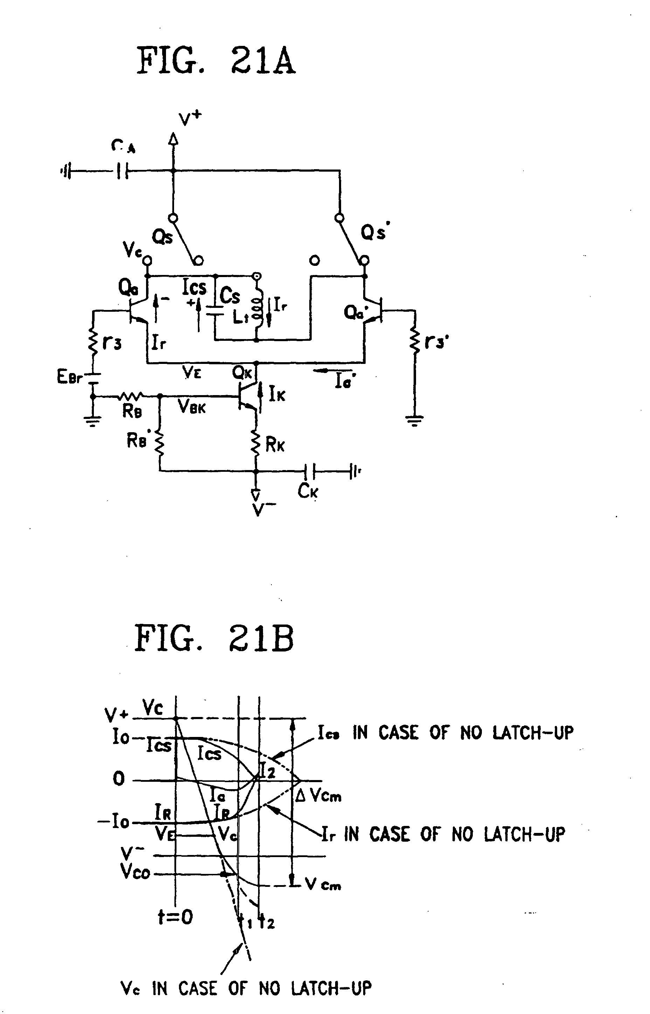

Figure 21A illustrates the procedure for reversing the recording current $I_r$ flowing through an inductor $L_t$ during a transient period of $0 \leq t \leq t_2$.

Here, as shown in Figure 21A, $Q_s$=OFF, $Q_s$'=ON, $Q_a$=ON, and $Q_a$'=OFF.

Even if the transistor $Q_s$ is off, the recording current $I_r=I_o$ alternates between on and off according to inductance characteristics, not being immediately off. In this case, the current $I_r$ is supplied to the inductance by means of a current $I_{CS}$ discharged from a parallel stray capacitance $C_s$ parasitic on the inductor $L_t$.

Due to this discharge, voltages at both ends of the stray capacitor $C_s$, that is, a collector voltage $V_c$ of the transistor $Q_a$ eventually falls rapidly. Additionally, since a charge voltage $V_{ct}$ of $L_t$ = the charge voltage $V_{cs}$ of $C_s \simeq 0$ in a steady state of t⟨0, there is, if ever, little charges in the stray capacitor $C_s$. Hence, a current charged in $L_t$ is discharged to $C_s$ and a current is negatively charged in $C_s$. Here, since $C_s$ is charged, the voltage $V_{cs}$ at both ends thereof becomes drastically large. As a result, a voltage at the (+) terminal of $L_t$ is lower than the collector voltage $V_c$ of the transistor $Q_a$.

If time required for the current flowing in $L_t$ to reach $I_r=I_o=0$ is $\tau$ and the maximum degree by which the collector voltage $V_c$ falls is $\Delta V_{cm}$, and resistance components included in $L_t$ is neglected, the following relationships are established from the principle of the conservation of energy:

$$L_t \cdot (I_o)^2 = C_s (\Delta V_{cm})^2 \tag{20}$$

$$\tau = (\pi/2) \cdot \sqrt{(L_t \cdot C_s)} \tag{21}$$

In a case of $|V(+)-V(-)| \langle \Delta V_{cm}$, the collectors and bases of the transistors $Q_a$ and $Q_k$ are reverse biased before $V_c$ falls by $\Delta V_{cm}$, and $V_c$ reaches $V_{co}$ (t=$t_1$), thereby shorting the collectors from the emitters of the transistors $Q_a$ and $Q_k$. As a result, a current supply path is formed to lead to $L_t$, the current $I_{cs}$ is discharged from $C_s$ and thus, a current is supplied to $L_t$ by the reversed current $-I_r$ and $-I_k$ flowing through the transistors $Q_a$ and $Q_k$.

Therefore, the discharge current $I_{cs}$ of $C_s$ and the voltage of $V_c$ are rapidly decreased.

Then, in a case of t=t2, $V_c$ becomes its minimum voltage, that is, falls by the maximum degree $\Delta V_{cm}$, the discharge current $I_{cs}$ is 0. Though it can be thought that the current $I_a'$ flowing through the transistor $Q_a'$ is also supplied to $L_t$, a little delay in turning off the transistor $Q_a'$ blocks the flow of the collector current $I_a'$. The waveforms of the above-described voltages and currents in the respective portions of the recording amplifier are illustrated in Figure 21B.

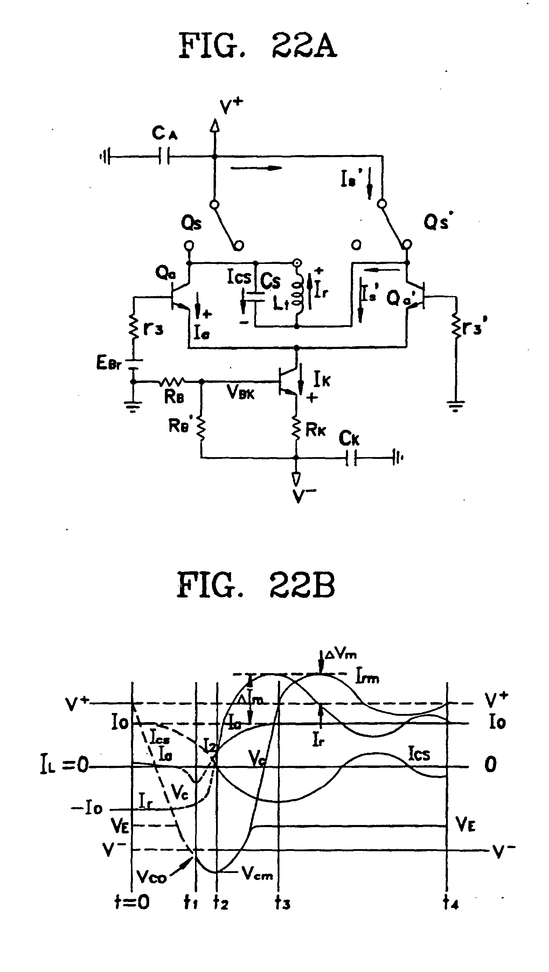

Figures 22A and 22B are views for explaining a transient phenomenon after switching for a current polarity reversal in the recording amplifier, showing the process of the reversal of the recording current $I_r$ during $t_2 \leq t \leq t_4$. When t=$t_2$, $I_r$ has already been reversed ($I_r$ ⟩0 and $I_a$ ⟩ 0), but the collectors and emitters of the transistors $Q_a$ and $Q_k$ remain shorted for a carrier accumulation time unique to the transistors, due to excess carriers accumulated in the bases thereof. Therefore, a $V^+$ potential is applied to an end of the winding $L_t$ at the primary side of the R/T via the transistor $Q_s'$, and a $V^-$ potential is applied to the other end thereof. Here, since $L_t$ is a low impedance, the collector current $I_a$ is rapidly increased and the charge current $I_{cs}$ of the stray capacitor Cs is added to the collector current $I_a$, simultaneously, thereby rapidly increasing the recording current $I_r$.

As a result, though the collector voltage $V_c$ of $Q_a$ generates an overshoot by $\Delta V_{cm}$, as shown in Figure 22B, it converges into a normal value $V^+$. On the other hand, when t=$t_3$, the recording current I, is overshot by $\Delta I_{rm}$ due to the current $I_o$ of a normal value, but converges into $I_o$, immediately. Here, $\Delta I_{rm}$ is the dose of current provided by the collector current $I_a$ of $Q_a$. Thus, the transient state is over, in which the polarity of the recording current is reversed by a phenomenon similar to latch-up.

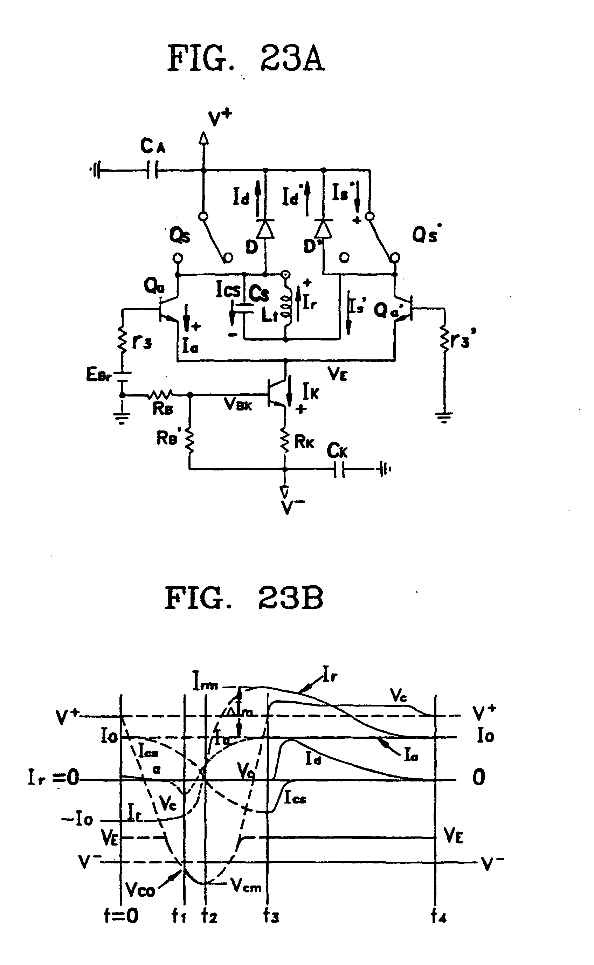

As shown in Figure 23A, the overshoot of respective collector voltages $V_c$ and $V_c$' can be prevented by inserting damper diodes D and D' between the respective collectors of the transistors $Q_a$ and $Q_a$' and the DC voltage supply terminal $V^+$. Diode currents $I_d$ and $I_d$' flow through the damper diodes D and D', respectively. Hence, the variations of a voltage and a current in each portion under ($t \leq t_3$), which are illustrated in Figure 23B, are different from those shown in Figure 22B.

As shown in Figure 23B, since the recording current $I_r$ is divided into the diode current $I_d$, the recording current $I_r$ converges into the current $I_o$ of a normal value.

As described above, since an amplifier for recording equalization should be provided with a linear amplifying function, a power transistor showing a large power dissipation is required. Thus, it can meet the demands of small-size and low-power. On the other hand, a recording amplifier employing a switching transistor exhibits the advantages of low power dissipation and small-size, while it is difficult to perform recording equalization for improvement of the rise characteristics of a recording current. As a result, this amplifier is not suited for high-speed, and high-density recording, either. A recording amplifier of a flyback switching type suggested in the present invention, which relies on a phenomenon similar to latch-up, can improve the rise characteristics of a recording current without recording equalization. Thus, it can be small and operate with a low power.

The three types of recording amplifiers are compared in [table 1].

[table 1]

| type of recording amplifier | recording characteristic improved | circuit for characteristic improvement | transistor for recording amplifier | power consumption (supply power) | circuit size for recording amplifier |
|---|---|---|---|---|---|
| constant current source linear amplification | recording equalization possible | recording amplifier | power amplification: large | large (±12V) | large |
| constant current source switching | difficult | | SW: small constant current source: medium | medium: constant current source (10V) | medium |
| flyback switching | latch-up similar mode | unnecessary | SW: small constant current source: small | small: (5V) | small |

However, the recording amplifiers of the above flyback switching type have a common problem when binary coded information (hereinafter referred to as a digital signal) including DC components is magnetically recorded.

As shown in Figure 20A, when the current $I_r$ for recording the digital signal, including DC components, flows through the magnetic head mounted on the rotational cylinder, the magnetic head current $I_h$ passes through the R/T and P/T. Thus, the recording current $I_r$ is decreased due to lack of the DC components and fine magnetizing is performed. The problem is a variation in the instantaneous value of the head current, $I_h$, of the head portion shown in Figure 20A. The P/T is not always needed.

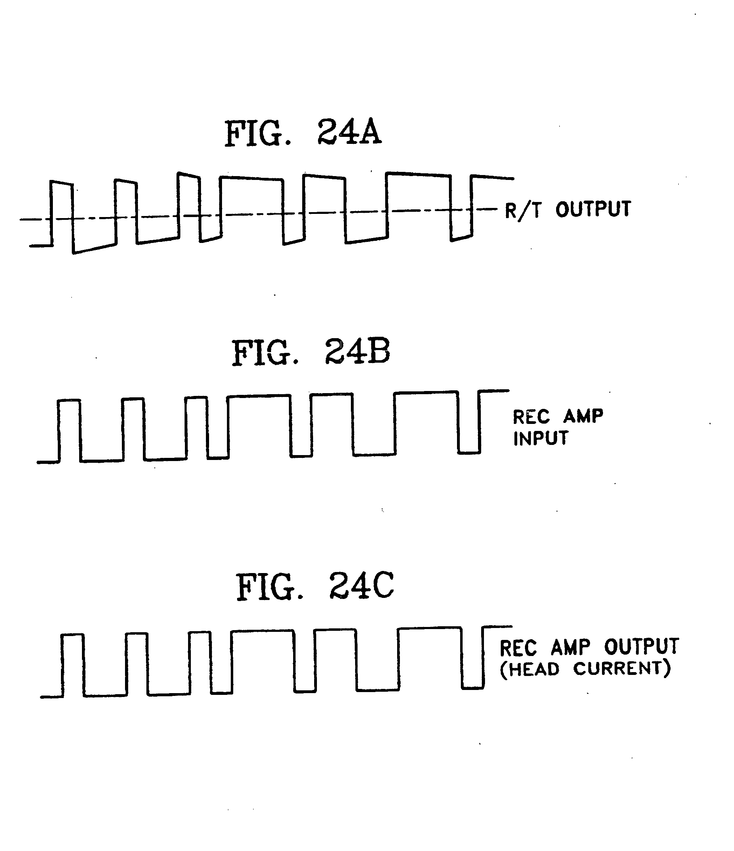

As a way to circumvent the above problem, a digital signal shape processing circuit and a recording amplifier can be provided in the rotational cylinder. As shown in Figures 24A-24C, a digital signal (see Figure 24A) distorted due to the passage through the R/T and R/T and the resulting lack of the DC components is corrected in the digital signal shape circuit (not shown). The signal (see Figure 24B) having the original restored DC components is input to the recording amplifier (not shown), and a magnetic head driving current (see Figure 24C) corresponding to this signal is provided. The problem inherent in this method is that provision of the digital signal shape circuit for processing signal waveforms and, especially, the recording amplifier in the rotational cylinder increases structure complexity, which in turn leads to an increase in cost. In particular, the provision of a DC power source in the rotational cylinder causes many problems including reliability conce/rns.

The distortion of the digital signal caused by lack of the recording current DC components resulting from the passage via the R/T effects the prevention of a large magnetization of the head. However, the distortion varies the instantaneous value at the rise of the recording current.

The variation of the instantaneous value at the rise of the recording current will be described in detail.

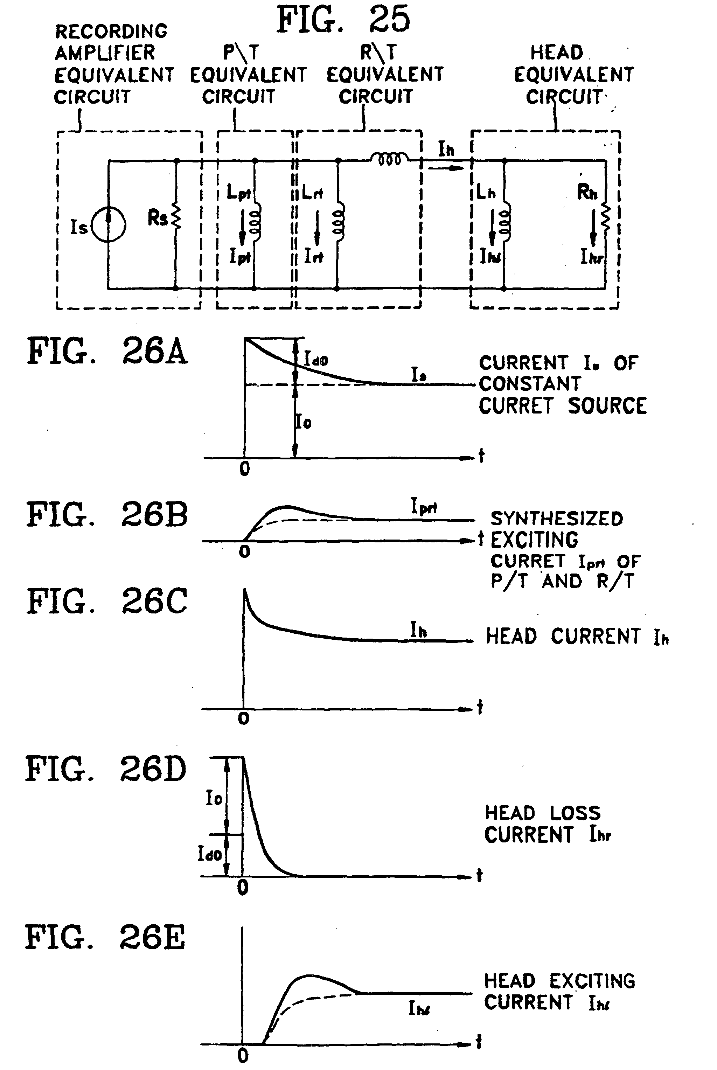

Figure 25 illustrates the equivalent circuits of a recording amplifier, a P/T, an R/T, and a head, which constitute a recording system with a focus given to the rise of the recording current. To determine the impact imposed by the lack of a DC current, the stray capacitor $C_a$ and the parallel stray capacitor $C_h$ are omitted, the ratio of the number of windings at the primary side to that of the windings of the secondary side in the R/T is given as 1, and a single magnetic head is provided. Thus, the constants of the equivalent circuit shown in Figure 20B are defined as follows and corrected into constants shown in Figure 25.

That is, $L_{pt}$ denotes an inductance at the primary side of the P/T, $L_{rt}$ denotes an inductance at the primary

**EP 0 758 782 B1**

side of the R/T, $L_k$ denotes a leakage inductance of the R/T, $L_h$ denotes a parallel inductance of the magnetic head, $R_h$ denotes a parallel loss resistance of the magnetic head, $L_{prt}$ denotes a synthesized inductance of $L_{pt}$ and $L_{rt}$, $L_{hprt}$ denotes a parallel inductance of the P/T, R/T and head, $R_s$ denotes an output resistance of a recording amplifier, $I_{pt}$ denotes an exciting current of the P/T, $I_{rt}$ is an exciting current of the R/T, $I_{hl}$ denotes an exciting current of the head, $I_{prt}$ denotes a synthesized exciting current, $I_{hr}$ denotes a loss current of the head, $I_o$ denotes an output current for controlling a constant current, $I_s$ denotes an output current of the recording amplifier, $I_{do}$ denotes an initial value of the damper current, $\delta$ denotes an attenuation time constant of the damper current, $R_d$ denotes an on-resistance of the damper diode, s denotes a complex frequency jw, t denotes time, and ¶ denotes a delta function.

By these definitions,

$$L_{prt} = (L_{pt} \cdot L_{rt})/(L_{pt}+L_{rt}) \tag{22}$$

$$I_{prt} = I_{pt}+I_{rt}$$

$$L_{hprt} = (L_h \cdot L_{prt})/(L_h+L_{prt}) \tag{23}$$

Here, $L_{prt} \gg L_k$ is generally encountered in practice, and for calculation simplicity, $L_k$ is included in $L_h$. Thus, the following approximate equation is obtained.

$$L_{prt} \gg L_k, \ L_h + L_k \rightarrow L_h \quad (L_h \gg L_k) \tag{24}$$

where $\alpha \equiv R_h/L_{prt}$, $\beta \equiv R_h/L_h$, $\gamma \equiv R_h/L_{hprt}$ (thus, $\alpha+\beta \equiv \gamma$), and $\delta \equiv R_d/L_{hprt}$.

As shown in Figures 23A and 23B, the output current $I_s$ of the recording amplifier is the sum of the constant current component $I_a (=I_o)$ controlled by the constant current controlling device and the current component $I_d$ ($Q_s' \rightarrow L_t \rightarrow D$).

With $R_d$ as the on-resistance of the damper diode, the attenuation time constant $R_d/L_t$ of $I_d$ is given as

$$L_t \fallingdotseq L_{hprt} \text{ or } R_d/L_t \fallingdotseq R_d/L_{hprt} = \delta \tag{25}$$

Therefore,

$$I_d = I_{do} \cdot \exp(-\delta \cdot t) \text{ or } Id = I_{do} \cdot \P/(s+\delta) \tag{26}$$

$$I_a = I_0 \text{ or } I_a = I_0 \cdot (\P/s) \tag{27}$$

Accordingly, the output current $I_s$ of the recording amplifier is given by

$$I_s = I_o + I_{do} \cdot \exp(-\delta \cdot t)$$

$$\text{or, } I_s = I_0 \cdot \P/s + I_{do} \cdot \P/(s+\delta) \tag{28}$$

Therefore, the synthesized exciting current $I_{prt}$ of the P/T and the R/T is calculated by

$$I_{prt} = \frac{1/(s \cdot L_{prt})}{1/(s \cdot L_{prt}) + 1/R_h} \cdot I_s$$

$$= \frac{a}{(s+r)} \cdot I_s = a \cdot I_0 \cdot [\P/s/(s + r)] + a \cdot I_{do} \cdot [\P/(s + \delta)/(s + r)]$$

**14**

$$= I_o \cdot a/r[\P/s - \P/(s + r)] + I_{do} \cdot a/(r - a)[\P/(s + a) - \P/(s + r)] \tag{29}$$

Equation (29) is Laplace-transformed into

$$I_{prt} = I_o \cdot (a/r) \cdot [1 - \exp(-r \cdot t)] + I_{do} \cdot (a/r - a) \cdot [\exp(-\delta \cdot t) - \exp(-r \cdot t)] \tag{30}$$

The head exciting current $I_{hl}$ is given by

$$I_{hl} = \frac{1/(s \cdot L_h)}{1/(s \cdot L_{prt}) + 1/R_h}$$

$$= I_s \cdot \beta/(s+r) = \beta/\alpha \cdot I_{prt} \tag{31}$$

where $\beta/\alpha = L_{prt}/L_h$.

Equation (31) is Laplace-transformed into

$$I_{hl} = (\beta/\alpha) \cdot I_{prt} \tag{32}$$

In contrast, the head loss current $I_{hr}$ is given as

$$I_{hr} = \frac{1/R_h}{1/(s \cdot L_{prt}) + 1/R_h} I_s$$

$$= \frac{s}{s+r} I_s = (1 - \frac{r}{s+r}) I_s$$

$$= I_o \cdot [\P/s - r \cdot \P/s/(s+r)] + I_{do} \cdot [\P/(s-a) -$$

$$r \cdot \P/(s+r)/(s+\delta)] = I_o \cdot [\P/(s+r)] + I_{do} \cdot [r/(r-\delta) \cdot \P/(s+r) + \delta/(\delta-r) \cdot \P/(s+\delta)] \tag{33}$$

Equation (33) is Laplace-transformed into

$$I_{hr} = I_o \cdot \exp(-r \cdot t) + I_{do} \cdot [r/(r-\delta) \cdot \exp(-r \cdot t) + \delta/(\delta - r) \cdot \exp(-\delta \cdot t)] \tag{34}$$

where

$$r/(r-\delta) = R_h/L_{hprt}/(R_h/L_{hprt} - R_d/L_{hprt})$$

$$= 1/(1 - R_d/R_h)$$

$$\delta/(r-\delta) = R_d/(R_d - R_h) = -R_d/R_h/(1 - R_d/R_h)$$

$$a/(r-\delta) = R_h/L_{hprt}/(R_h/L_{hprt} - R_d/L_{hprt})$$

$$= (L_{hprt}/L_{hprt})/(1-R_d/R_h)$$

$$B/(r-\delta) = (L_{hprt}/L_h)/(1-R_d/R_h)$$

Therefore,

$$I_{prt} = I_o \cdot [(L_{hprt}/L_{hprt}) \cdot \{1-\exp(-r \cdot t)\}] +$$

$$I_{do} \cdot [(L_{hprt}/L_{hprt})/(1-R_d/R_h) \cdot \{\exp(-\delta \cdot t)-\exp(-r \cdot t)\}] \qquad (35)$$

$$I_{hl} = I_o \cdot [(L_{hprt}/L_h) \cdot \{1-\exp(-r \cdot t)\}] +$$

$$I_{do} \cdot [(L_{hprt}/L_h)/(1-R_d/R_h) \cdot \{\exp(-\delta \cdot t)-\exp(-r \cdot t)\}] \qquad (36)$$

$$I_{hr} = I_o \cdot \exp(-r \cdot t) + I_{do} \cdot [1(1-R_d/R_h) \cdot \exp(-r \cdot t) +$$

$$(-R_d/R_h)/(1-R_d/R_h) \cdot \exp(-\delta \cdot t)] \qquad (37)$$

To further simplify these results, the on-resistance $R_d$ of the damper diode D is considered to be much smaller than the head loss resistance $R_h$.

$$R_h \gg R_d \qquad (38)$$

Hence

$$I_{prt} = I_o \cdot [(L_{hprt}/L_{prt}) \cdot \{1-\exp(-r \cdot t)\}] +$$

$$I_{do} \cdot [(L_{hprt}/L_{prt}) \cdot \{\exp(-\delta \cdot t)-\exp(-r \cdot t)\}]$$

$$= (L_{hprt}/L_{prt})[I_o \cdot \{1-\exp(-r \cdot t)\} + I_{do} \cdot \{\exp(-\delta \cdot t)$$

$$-\exp(-r \cdot t)\}] \dots (39) \qquad (39)$$

$$I_{hl} = I_o \cdot [(L_{hprt}/L_h) \cdot \{1-\exp(-r \cdot t)\}] +$$

$$I_{do} \cdot [(L_{hprt}/L_h) \cdot \{\exp(-\delta \cdot t)-\exp(-r \cdot t)\}]$$

$$= (L_{hprt}/L_h)[I_o \cdot \{1-\exp(-r \cdot t)\} + I_{do} \cdot \{\exp(-\delta \cdot t)$$

$$-\exp(-r \cdot t)\}] \qquad (40)$$

$$I_{hr} = I_o \cdot \exp(-r \cdot t) + I_{do} \cdot \exp(-r \cdot t) \qquad (41)$$

The current $I_a$ of the constant current source, the synthesized exciting current $I_{prt}$ of the P/T and the R/T, the head loss current $I_{hr}$, and the head exciting current $I_{hl}$ are illustrated in Figures 26A-26E.

$I_s$ shown in Figure 26A can be expressed as equation (28), $I_{prt}$ shown in Figure 26B can be expressed as equation (39), $I_h$ shown in Figure 26C is the sum of $I_{hr}$ and $I_{hl}$, $I_{hr}$ shown in Figure 26D can be expressed as equation (41), and $I_{hi}$ shown in Figure 26E can be expressed as equation (40).

In the recording amplifier of a switching type, an amplitude component $I_{do}$ of a transient pulse current in the current source output $I_s$ is generated by energies $E_{pt}$, $E_{rt}$, and $E_h$ accumulated in inductance loads $L_{pt}$, $L_{rt}$, and $L_h$ of the amplifier. By using the synthesized current $I_{prt}$ and synthesized inductance $L_{prt}$ of the P/T and the R/T, the value $E_{prt}$ of the accumulated energy can be given by

$$E_{prt} \equiv L_{pt} \cdot I_{pt}^2/2 + L_{rt} \cdot I_{rt}^2/2 = L_{pt} \cdot I_{pt}^2/2 \qquad (42)$$

The energy $E_h$ accumulated in the magnetic head inductance is given as

$$E_h = L_h \cdot I_{hl}^2/2 \qquad (43)$$

Accordingly, the sum $E_t$ of the energies accumulated in the inductance loads $L_{prt}$ and $L_h$ of the recording amplifier is expressed as

$$E_t = E_{prt} + E_h \qquad (44)$$

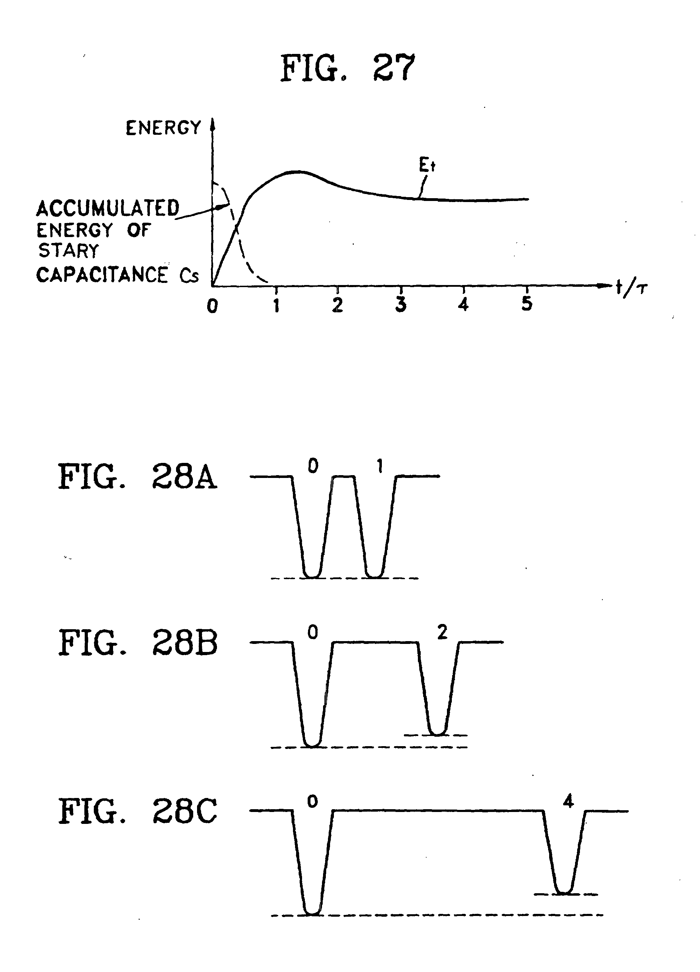

Though $E_t$ is obtained by substituting equations (39)-(40) for equation (38), it can not be simplified into an equation. Thus, the result of this calculation is shown in Figure 27. As shown in Figure 27, though the accumulated energy $E_t$ generates an overshoot, it is attenuated as time goes on and converges into a predetermined value.

A current switching time $t/\tau$ corresponding to a bit length of input data having a discrete value varies to 1, 2, 3, or 4. The accumulated electromagnetic energy $E_t$ at the time point of a current switching is transferred to the parallel stray capacitor $C_s$ and converted into accumulated charge energy. Thus, as shown in Figures 28A-28C, flyback pulses are generated and the amplitudes of these pulses are proportional to the square root of the accumulated energy.

That is, Figure 28A illustrates the amplitude of a flyback pulse in a switching time $t/\tau$ of 1, Figure 28B illustrates the amplitude of a flyback pulse in a switching time $t/\tau$ of 2, and Figure 28C illustrates the amplitude of a flyback pulse in a switching time $t/\tau$ of 4. From the figures, it is noted that the amplitude of the flyback pulse is attenuated in the passage of time.

The accumulated energy of $C_s$ is necessarily converted into electromagnetic energy and produces the initial value $I_{do}$ of a transient pulse current component. Thus, the recording amplifier of a flyback switching type, in which electromagnetic accumulated energy is attenuated with the passage of time, exhibits the problem that an instantaneous value at a current rise varies during the reversal of a current polarity.

Another embodiment of the recording amplifier of a flyback switching type is illustrated in Figure 29, to overcome the above problem.

In Figure 29, the recording amplifier has a shaping driver 10 for providing positive and negative signals corresponding to a binary coded input signal, a current switching device 12 for switching a current supplied to a push-pull amplifier 14 in response to the positive and negative signals, the push-pull amplifier 14 for receiving the positive and negative polarity signals and providing a recording current obtained by a rapid switching, a constant current controlling device 16 for controlling a constant current transmitted through the push-pull amplifier 14, and a compensation signal generating portion 20 for generating a compensation signal for controlling an instantaneous value to be a predetermined value against variations in the instantaneous value of the recording current.

Figure 30 illustrates a circuit diagram of the recording amplifier shown in Figure 29, for explaining the operational principle thereof.

In Figure 30, amp transistors $Q_a$ and $Q_a'$ are npn transistors, and the current switching device 12 has pnp transistors $Q_s$ and $Q_s'$. Here, a common signal source $E_i$ is used to drive the bases of the transistors $Q_a$ and $Q_s$, and $E_{ab}$ and $E_{sb}$ are applied to the bases of the transistors $Q_a$ and $Q_s$, respectively, by resistance division from the common signal source $E_i$. The respective bases of the transistors $Q_a'$ and $Q_s'$ are driven by a common signal source $E_i'$ having a polarity opposite to that of $E_i$, and $E_{ab}'$ and $E_{sb}'$ are applied to the bases of the transistors $Q_a'$ and $Q_s'$, respectively, by resistance division from the common signal source $E_i'$.

A common collector of the transistors $Q_a$ and $Q_s$ is connected to one terminal of the primary side of an R/T, while a common collector of the transistors $Q_a'$ and $Q_s'$ is connected to the other terminal of the primary side of the R/T. Thus, a recording current is provided to the head via the R/T, or the R/T and P/T. A diode D is inserted between a DC voltage supply terminal $V^+$ and the common collector of the transistors $Q_a$ and $Q_s$, while a diode D' is inserted between a DC voltage supply terminal $V^+$ and the common collector of the transistors $Q_a'$ and $Q_s'$.

Meanwhile, the common emitter of the transistors $Q_a$ and $Q_a'$ is connected to the collector of a constant current

controlling transistor $Q_k$, and the emitter of the constant current controlling transistor $Q_k$ is connected to a current feedback resistor $R_k$. Thus, a current $I_k$ ($=I_a+I_a'$) almost proportional to a base voltage $E_{kb}$ of the constant current controlling transistor $Q_k$ flows, thus controlling the peak-to-peak value of a normal amplitude of the recording current $I_r$.

The synthesized exciting current $I_{prt}$ of the P/T and R/T of equation (39) and the head exciting current $I_{hl}$ of equation (40) are given as follows:

$$I_{prt} = (L_{hprt}/L_{prt})\cdot[(I_o+I_{do})\cdot\{1-\exp(-r\cdot t)\}-I_{do}\cdot\{1-\exp(-\delta\cdot t)\}] \qquad (45)$$

$$I_{hl} = (L_{hprt}/L_h)\cdot[(I_o+I_{do})\cdot\{1-\exp(-r\cdot t)\}-I_{do}\cdot\{1-\exp(-\delta\cdot t)\}] \qquad (46)$$

Since an attenuation time constant $\gamma$ of a current component $I_o+I_{do}$ is larger than a time constant $\delta$ of a current component $I_{do}$, both components being included in the synthesized exciting current $I_{prt}$, $I_o+I_{do}$ immediately reaches a normal value, but it takes a relatively long time for $I_{do}$ to reach a normal value and thus the variation of $I_{prt}$ causes a problem.

To remove this current variation, the compensation current $\Delta I_{prt}$ is provided. Then, the synthesized current $I_{prt}$ does not vary and is maintained to be a predetermined value in spite of a change in the bit length of input data. Consequently, there is no variation in electromagnetic energy accumulated in the synthesized inductance $L_{prt}$ of the inductance $L_{rt}$ at the primary side of the R/T and the inductance Lpt at the primary side of the P/T.

$$\Delta I_{prt} = (L_{hprt}/L_{prt})\cdot I_{do}\cdot(1-\exp)-\delta\cdot t)\} \qquad (47)$$

$$I_{prt}+\Delta I_{prt}=(L_{hprt}/Lpr+_{Ido})\{1-\exp(-r\cdot t)\} \qquad (48)$$

It is possible to prevent the variation of the head exciting current $I_{hl}$ by transmitting the same compensation current $\Delta I_{hl}$ expressed as equation (49) with respect to the head exciting current $I_{hl}$.

$$\Delta I_{hl}=(L_{hprt}/L_h)\cdot I_{do}\{1-\exp(-\delta\cdot t)\} \qquad (49)$$

Given the sum value of the compensation current as $\Delta I_{hrpt}$,

$$\Delta I_{hprt} =\Delta I_{prt}+\Delta I_{hl}=I_{do}\cdot\{1-\exp(-\delta\cdot t)\} \qquad (50)$$

$$I_{hprt}+\Delta I_{hprt}=(I_o+I_{do})\cdot\{1-\exp(-r\cdot t)\} \qquad (51)$$

Thus, it is necessary to apply a compensation signal $V_{cc}$ for generating the compensation current $\Delta I_{hprt}$ to the base voltage $E_{kb}$ of the current controlling transistor $Q_k$. A method for generating $V_{cc}$ will be described in connection with the waveforms shown in Figures 31A-31E.

That is, flyback pulses shown in Figures 31A and 31B are generated in the collectors of the transistors $Q_a$ and $Q_a'$, after the reversal of the polarity of the recording current $I_r$. These flyback pulses are mixed via resistors $R_{ac}$, $R_{ac}'$, and $R_{ci}$, and amplified and polarity-reversed in an operation amplifier OP, thereby generating a synthesized pulse $V_{bc}$ shown in Figure 31C. This pulse is applied to the base of a switching transistor $Q_c$ for generating a compensation signal. Here, a predetermined reference voltage $E(=E_{co}+V(-))$ is applied to the emitter of the switching transistor $Q_c$ and determined as a voltage for turning on the switching transistor $Q_c$. Therefore, the collector voltage $V_{cc}$ of the switching transistor $Q_c$ shows a charge and discharge waveform shown in Figure 31D.

A parameter for forming this waveform is given by a power-supply voltage $E_c$ of $Q_c$ and a time constant $R_cC_c$ as follows:

$$V_{cc} = E_{ck} + (E_c - E_{ck})[1 - \exp\{-t/R_c \cdot C_c\}]$$

$$= E_{ck}[1 + (E_c/E_{ck} - 1)\{1 - \exp(-t/R_c C_c)\}] \tag{52}$$

The compensation current $\Delta I_{hprt}$ can be generated by mating each integer of the above equation (52) with its counterpart of equation (51) and selecting a proper waveform-forming parameter.

The waveform of the current $I_k$ flowing by the compensation voltage signal $V_{cc}$ (see Figure 31D) injected into the base of the current controlling transistor $Q_k$ is illustrated in Figure 31E.

As a result of injecting the compensation signal into the base of the current controlling transistor $Q_k$, the sum of electromagnetic energies accumulated in the inductances of a recording system are consistently conserved without any attenuation. Thus, despite a variation in a switching time of the recording current polarity corresponding to the bit length of input data, there is no change in the amplitude of a flyback pulse in contrast to the pulses shown in Figures 28A-28C. In other words, recording current rising characteristics (a rise time and a fall instantaneous value) at the moment of switching the polarity of the recording current can be maintained to be stable due to the very constant width and amplitude of the flyback pulse.

Figure 32 shows the calculated values of compensation currents added to stabilize the switching characteristics of the recording current.

In the second embodiment of the present invention, the recording current rise characteristics during switching the polarity of the recording current can be stably maintained by compensating for a variation of the instantaneous value of the recording current resulting from use of a pulse transformer and a rotational transformer.

As described above, since the magnetic recording device of the present invention employs a switching recording amplifier for controlling a constant current, transistors used in the magnetic recording device exhibit a low power dissipation and the need for a power transistor is obviated. These advantages enable fabrication of a compact and a low-power recording amplifier.

Further, without an additional recording equalizer, the rise characteristics of a head current is improved and the head current has an overshoot characteristic, as well. Thus, the start of a magnetic flux generated from the head current can be accelerated, the resolution of a magnetized pattern recorded on tape can be increased, and information can be recorded at a speed of several to tens of Mpbs with a high density.

Embodiments of the present invention have the effects that the rise characteristics of the recording current during switching the polarity of the recording current can be maintained to be very stable by controlling a constant current controlling device and thus adding a stabilizing compensation current, and the aperture rate of an eye pattern reproduced from a tape on which information is recorded by the recording device of the present invention is increased.

## Claims

1.  A magnetic recording device for recording a digital signal ($E_{io}$) by providing a recording current (Ir) indicative of digital information to a magnetic head (H'D), comprising:

    a shaping driver (10) for positive and negative signals whose polarities are reversed, corresponding to said digital information;
    push-pull means (14) for generating a recording current ($I_r$) corresponding to said positive and negative signals and generating a transient pulse current during reversal of the polarity of said recording current ($I_r$); and
    current switching means (12) for switching a current flowing through said push-pull means (14) in response to said positive and negative signals,

    **characterised in that**:

    said digital signal is recorded on said magnetic recording medium (5) on the basis of said transient pulse current , whereby the switching speed of the recording current is increased by using this transient pulse current.

2.  A magnetic recording device as claimed in claim 1, further comprising constant current controlling means (16) for controlling entire current signals provided to said push-pull means (14) to be constant.

3.  A magnetic recording device as claimed in claim 1, further comprising:

means (20) for generating a compensation signal ($V_{cc}$) against a variation in the instantaneous value of a recording current ($I_r$) generated in said push-pull means (14); and

constant current controlling means (16) for controlling said instantaneous value of said recording current ($I_r$) to be constant in response to said compensation signal ($V_{cc}$).

**4.** A magnetic recording device as claimed in claim 1, comprising:

a pair of switches (SW, SW' , $Q_s$, $Q_s'$) for switching positive and negative current signals;

a first amplifying device ($Q_a$) for generating a recording current ($I_r$) corresponding to a current signal switched by one of said pair of switches (SW, $Q_s$) and generating a transient pulse current during reversal of the polarity of said recording current ($I_r$) to said magnetic head (H'D);

a second amplifying device ($Q_a'$) for generating a recording current ($I_r$) corresponding to a current signal switched by the other switch (SW', $Q_s'$) and generating a transient pulse current during reversal of the polarity of said recording current ($I_r$) to said magnetic head (H'D); and

a constant current controlling device ($I_o$) for controlling a constant current flowing through said first ($Q_a$) and second ($Q_a'$) amplifying devices.

**5.** A magnetic recording device as claimed in claim 1 for recording a digital signal by providing a recording current corresponding to digital information via a rotary transformer to a magnetic head and magnetizing a magnetic recording medium, comprising:

a pair of switches (SW, SW', $Q_s$, $Q_s'$) for switching positive and negative current signals;

a first amplifying device ($Q_a$) for generating a recording current corresponding to a current signal switched by one of said pair of switches (SW, $Q_s$) and generating a transient pulse current during reversal of the polarity of said recording current to said magnetic head (H'D);

a second amplifying device ($Q_a'$) for generating a recording current corresponding to a current signal switched by the other switch (SW', $Q_s'$) and generating a transient pulse current during reversal of the polarity of said recording current ($I_r$) to said magnetic head (H'D);

a compensation signal generator (20, OP, $R_{ci}$, $R_{ci}'$, $Q_c$, $R_c$, $C_c$) for generating a compensation signal ($V_{cc}$) in the form of a voltage signal according to a variation of the instantaneous value of a recording current ($I_r$) generated, caused by passage via said rotary transformer; and

a constant current controlling device ($Q_k$) for controlling said instantaneous value of said recording current ($I_r$) to be constant in response to said compensation signal ($V_{cc}$),

wherein said transient pulse current flows through said magnetic head (H'D) and a digital signal is recorded on said magnetic recording medium.

**6.** A magnetic recording device as claimed in claim 4 or 5, further comprising:

a first damper device (D) having one end inserted between one of said pair of switches ($Q_s$) and said first amplifying device ($Q_a$), and the other end connected to a power source ($V^+$); and

a second damper device (D') having one end inserted between the other switch ($Q_s'$) and said second amplifying device ($Q_a'$), and the other end connected to said power source ($V^+$),

wherein said transient current rapidly converges into a normal current value by means of said first and second damper devices (D'D).

**7.** A magnetic recording device as claimed in claim 1 comprising:

a first complementary semiconductor device ($Q_a$) for generating a recording current corresponding to said positive signal and generating a transient pulse current during reversal of the polarity of said recording current to said magnetic head;

a second complementary semiconductor device ($Q_a'$) connected in parallel to said first complementary semiconductor device, for generating a transient pulse current during reversal of the polarity of said recording current to said magnetic head; and

a constant current controlling device ($Q_k$) commonly connected to said first and second complementary semiconductor devices ($Q_a$ $Q_a'$).

8. A magnetic recording device according to claim 7, further comprising:

a compensation signal generator (20) for generating a compensation signal ($V_{cc}$) in the form of a voltage signal according to a variation of the instantaneous value of a recording current ($I_r$) generated, caused by passage via a rotary transformer.

9. A magnetic recording device as claimed in claim 7 or 8, further comprising:

a first damper device (D) having one end connected to said first complementary semiconductor device ($Q_a$), and the other end connected to a power source ($V^+$); and

a second damper device (D') having one end connected to said second complementary semiconductor device ($Q_a'$), and the other end connected to said power source ($V^+$),
     wherein said transient current rapidly converges into a normal current value by means of said first and second damper devices (D, D').

10. A magnetic recording device according to claim 1 for recording a digital signal by providing a recording current corresponding to digital information to a magnetic head and reproducing said recorded digital signal, comprising:

first and second DC voltage supply terminals ($V^+,V^-$) for receiving predetermined first and second DC voltages; to

a first pnp transistor ($Q_s$) having a base connected to said shaping driver (10) and an emitter connected to said first DC voltage supply terminal ($V^+$), for activating according to said negative signal;

a second pnp transistor ($Q_s'$) having a base connected to said shaping driver (10) and an emitter connected to said first DC voltage supply terminal ($V^+$), for activating according to said positive signal;

a first npn transistor ($Q_a$) having a base connected to said shaping driver and a collector connected to the collector of said first pnp transistor ($Q_s$), for generating a rising pulse current at the moment when said first pnp transistor ($Q_s$) is off and providing said rising pulse current as a recording current to said magnetic head;

a second npn transistor ($Q_a'$) having a base connected to said shaping driver (10) and a collector connected to the collector of said second pnp transistor ($Q_s'$), for generating a rising pulse current at the moment when said second pnp transistor ($Q_s'$) is off and providing said rising pulse current as a recording current to said magnetic head; and

a third npn transistor ($Q_k$) having a base connected to said first DC voltage supply terminal ($V^+$), a collector connected commonly to the emitters of said first and second npn transistors ($Q_a$, $Q_a'$), an emitter connected to a variable resistor ($R_k$) for controlling a current which is connected to said second DC voltage supply terminal ($V^-$).

11. A magnetic recording device as claimed in claim 10, further comprising:

a comparator (OP) connected to the collectors of said first and second npn transistors ($Q_s$, $Q_s'$), for comparing a predetermined reference value with an instantaneous value of a recording current ($I_r$) changed due to the passage of said recording current ($I_r$) via a rotary transformer; and

an integrator ($R_c$, $C_c$) for integrating the output of said comparator and generating a compensation signal ($V_{cc}$).

**12.** A magnetic recording device as claimed in claim 10 or 11, wherein a transient pulse current is generated to have rise characteristics rapidly improved by adjusting the magnitudes of said first and second DC voltages ($V^+$, $V^-$), turning off said first to third npn transistors ($Q_a$, $Q_a'$, $Q_k$) during switching the polarity of said recording current ($I_r$), and applying a voltage corresponding to the entire power source to a magnetic head (H'D).

**13.** A magnetic recording device as claimed in claim 10, 11 or 12, further comprising:

a first damper device (D) having one end connected to the common collector of said first pnp transistor ($Q_s$) and said first npn transistor ($Q_a$), and the other end connected to said first DC voltage supply terminal ($V^+$); and to

a second damper device (D') having one end connected to the common collector of said second pnp transistor ($Q_s'$) and said second npn transistor ($Q_a'$), and the other end connected to said first DC voltage supply terminal ($V^+$),

wherein a rising pulse current rapidly converges into a normal current value by means of said first and second damper devices (D, D').

**14.** A magnetic recording method for recording a digital signal on a magnetic recording medium by a recording current indicative of digital information provided to a magnetic head (H'D), said method comprising the steps of:

generating positive and negative signals whose polarities are reversed, corresponding to said digital information; and

generating a recording current ($I_r$) corresponding to said positive and negative signals, generating a transient pulse current during switching the polarity of said recording current ($I_r$), and providing said transient pulse current to said magnetic head (H'D),

**characterised in that**:

said digital signal is recorded on said magnetic recording medium (5) on the basis of said transient pulse current , whereby the switching speed of the recording current is increased by using this transient pulse current.

**15.** A magnetic recording method as claimed in claim 14, further comprising the steps of:

generating a compensation signal ($V_{cc}$) against a variation in the instantaneous value of said recording current ($I_r$); and
controlling the instantaneous value of said recording current ($I_r$) to be constant in response to said compensation signal ($V_{cc}$).

**Patentansprüche**

**1.** Magnetaufzeichnungsvorrichtung zum Aufzeichnen eines digitalen Signals ($E_{io}$) durch Zuführen eines Aufzeichnungsstroms (Ir), der digitale Informationen anzeigt, zu einem Mägnetkopf (H'D), die umfasst:

einen Formungstreiber (10) für positive und negative Signale, deren Polaritäten entsprechend den digitalen Informationen umgekehrt werden;

eine Gegentakteinrichtung (14), die einen Aufzeichnungsstrom ($I_r$) erzeugt, der den positiven und negativen Signalen entspricht, und während der Umkehrung der Polarität des Aufzeichnungsstrom ($I_r$) einen Übergangs-Impulsstrom erzeugt; und

eine Stromumschalteinrichtung (12), die einen Strom, der durch die Gegentakteinrichtung (14) fließt, in Reaktion auf die positiven und negativen Signale umschaltet,

**dadurch gekennzeichnet, dass**:

das digitale Signal auf das Magnetaufzeichnungsmedium (5) auf Basis des Übergangs-Impulsstroms aufgezeichnet wird, wobei die Umschaltgeschwindigkeit des Aufzeichnungsstroms unter Verwendung dieses Übergangs-Impulsstroms erhöht wird.

2. Magnetaufzeichnungsvorrichtung nach Anspruch 1, die des Weiteren eine Konstantstrom-Steuereinrichtung (16) umfasst, die alle Stromsignale, die der Gegentakteinrichtung (14) zugeführt werden, so steuert, dass sie konstant sind.

3. Magnetaufzeichnungsvorrichtung nach Anspruch 1, die des Weiteren umfasst:

eine Einrichtung (20), die ein Kompensationssignal ($V_{cc}$) für eine Änderung des Momentanwertes eines Aufzeichnungsstroms ($I_r$) erzeugt, der in der Gegentakteinrichtung (14) erzeugt wird, und

eine Konstantstrom-Steuereinrichtung (16), die den Momentanwert des Aufzeichnungsstroms ($I_r$) in Reaktion auf das Kompensationssignal ($V_{cc}$) so steuert, dass er konstant ist.

4. Magnetaufzeichnungsvorrichtung nach Anspruch 1, die umfasst:

ein Paar Schalter (SW, SW', $Q_s$, $Q_s'$), die positive und negative Stromsignale schalten;

eine erste Verstärkungsvorrichtung ($Q_a$), die einen Aufzeichnungsstrom ($I_r$) erzeugt, der einem Stromsignal entspricht, das von einem des Paars von Schaltern (SW, $Q_s$) geschaltet wird, und während der Umkehrung der Polarität des Aufzeichnungsstroms ($I_r$) zu dem Magnetkopf (H'D) einen Übergangs-Impulsstrom erzeugt;

eine zweite Verstärkungsvorrichtung ($Q_a'$), die einen Aufzeichnungsstrom ($I_r$) erzeugt, der einem Stromsignal entspricht, das von dem anderen Schalter (SW', $Q_s'$) geschaltet wird, und während der Umkehrung der Polarität des Aufzeichnungsstroms ($I_r$) zu dem Magnetkopf (H'D) einen Übergangs-Impulsstrom erzeugt; und

eine Konstantstrom-Steuervorrichtung ($I_o$), die einen Konstantstrom steuert, der durch die erste ($Q_a$) und die zweite ($Q_a'$) Verstärkungsvorrichtung fließt.

5. Magnetaufzeichnungsvorrichtung nach Anspruch 1 zum Aufzeichnen eines digitalen Signals durch Zuführen eines Aufzeichnungsstroms, der digitalen Informationen entspricht, zu einem Magnetkopf und Magnetisieren eines Magnetaufzeichnungsmediums, die umfasst:

ein Paar Schalter (SW, SW', $Q_s$, $Q_s'$), die positive und negative Stromsignale schalten;

eine erste Verstärkungsvorrichtung ($Q_a$), die einen Aufzeichnungsstrom erzeugt, der einem Stromsignal entspricht, das von einem des Paars von Schaltern (SW, $Q_s$) geschaltet wird, und während der Umkehrung der Polarität des Aufzeichnungsstroms zu dem Magnetkopf (H'D) einen Übergangs-Impulsstrom erzeugt;

eine zweite Verstärkungsvorrichtung ($Q_a'$), die einen Aufzeichnungsstrom erzeugt, der einem Stromsignal entspricht, das von dem anderen Schalter (SW', $Q_s'$) geschaltet wird, und während der Umkehrung der Polarität des Aufzeichnungsstroms ($I_r$) zu dem Magnetkopf (H'D) einen Übergangs-Impulsstrom erzeugt;

einen Kompensationssignalgenerator (20, OP, $R_{ci}$, $R_{ci}'$, $Q_c$, $R_c$, $C_c$), der ein Kompensationssignal ($V_{cc}$) in Form eines Spannungssignals entsprechend einer Änderung des Momentanwertes eines erzeugten Aufzeichnungsstroms ($I_r$) erzeugt, die

durch Durchgang durch den Drehumformer verursacht wird; und

eine Konstantstrom-Steuervorrichtung ($Q_k$), die den Momentanwert des Aufzeichnungsstroms ($I_r$) in Reaktion auf das Kompensationssignal ($V_{cc}$) so steuert, dass er konstant ist,

wobei der Durchgangs-Impulsstrom durch den Magnetkopf (H'D) fließt und ein digitales Signal auf dem Magnetaufzeichnungsmedium aufgezeichnet wird.

**6.** Magnetaufzeichnungsvorrichtung nach Anspruch 4 oder 5, die des Weiteren umfasst:

eine erste Dämpfungsvorrichtung (D), deren eines Ende zwischen einen der Paare von Schaltern ($Q_s$) und die erste Verstärkungsvorrichtung ($Q_a$) eingeführt ist, und deren anderes Ende mit einer Spannungsquelle ($V^+$) verbunden ist; und

eine zweite Dämpfungsvorrichtung (D'), deren eines Ende zwischen den anderen Schalter ($Q_s'$) und die zweite Verstärkungsvorrichtung ($Q_a'$) eingeführt ist, und deren anderes Ende mit der Spannungsquelle ($V^+$) verbunden ist,

wobei der Übergangsstrom durch die erste und die zweite Dämpfungsvorrichtung (D'D) schnell in einen normalen Stromwert übergeht.

**7.** Magnetaufzeichnungsvorrichtung nach Anspruch 1, die umfasst:

eine erste Komplementär Halbleitervorrichtung ($Q_a$), die einen Aufzeichnungsstrom erzeugt, der dem positiven Signal entspricht, und während der Umkehrung der Polarität des Aufzeichnungsstroms zu dem Magnetkopf einen Übergangs-Impulsstrom erzeugt;

eine zweite Komplementär-Halbleitervorrichtung ($Q_a'$), die parallel zu der ersten Komplementär-Halbleitervorrichtung geschaltet ist und während der Umkehrung der Polarität des Aufzeichnungsstroms zu dem Magnetkopf einen Übergangs-Impulsstrom erzeugt; und

eine Konstantstrom-Steuervorrichtung ($Q_k$), die gemeinsam mit der ersten und der zweiten Komplementär-Halbleitervorrichtung ($Q_a$, $Q_a'$) verbunden ist.

**8.** Magnetaufzeichnungsvorrichtung nach Anspruch 7, die des Weiteren umfasst:

einen Kompensationssignalgenerator (20), der ein Kompensationssignat ($V_{cc}$) in Form eines Spannungssignals entsprechend einer Änderung des Momentanwertes eines Aufzeichnungsstroms ($I_r$) erzeugt, die durch Durchgang durch einen Drehumformer verursacht wird.

**9.** Magnetaufzeichnungsvorrichtung nach Anspruch 7 oder 8, die des Weiteren umfasst:

eine erste Dämpfungsvorrichtung (D), deren eines Ende mit der ersten Komplementär-Halbleitervorrichtung ($Q_a$) verbunden ist, und deren anderes Ende mit einer Spannungsquelle ($V^+$) verbunden ist; und
eine zweite Dämpfungsvorrichtung (D'), deren eines Ende mit der zweiten Komplementär-Halbleitervorrichtung ($Q_a'$) verbunden ist und deren anderes Ende mit der Spannungsquelle ($V^+$) verbunden ist,

wobei der Übergangsstrom durch die erste und die zweite Dämpfungsvorrichtung (D, D') schnell in einen normalen Stromwert übergeht.

**10.** Magnetaufzeichnungsvorrichtung nach Anspruch 1 zum Aufzeichnen eines digitalen Signals durch Zuführen eines Aufzeichnungsstroms, der digitalen Informationen entspricht, zu einem Magnetkopf und Wiedergeben des aufgezeichneten digitalen Signals, die umfasst:

einen ersten und einen zweiten Gleichspannungs-Zuführanschluss ($V^+$, $V^-$) zum Empfangen einer vorgegebenen ersten und zweiten Gleichspannung;

einen ersten PNP-Transistor ($Q_s$) mit einer Basis, die mit dem Formungstreiber (10) verbunden ist, und einem Emitter, der mit dem ersten Gleichspannungs-Zuführanschluss ($V^+$) verbunden ist, um entsprechend dem negativen Signal anzuschalten;

einen zweiten PNP-Transistor ($Q_s'$) mit einer Basis, die mit dem Formungstreiber (10) verbunden ist, und einem Emitter, der mit dem ersten Gleichspannungs-Zuführanschluss ($V^+$) verbunden ist, um entsprechend dem positiven Signal anzuschalten;

einen ersten NPN-Transistor ($Q_a$) mit einer Basis, die mit dem Formungstreiber verbunden ist, und einem Kollektor, der mit dem Kollektor des PNP-Transistors ($Q_s$) verbunden ist, um einen ansteigenden Impulsstrom in dem Moment zu erzeugen, in dem der erste PNP-Transistor ($Q_s$) abgeschaltet wird, und den ansteigenden Impulsstrom dem Magnetkopf als einen Aufzeichnungsstrom zuzuführen;

einen zweiten NPN-Transistor ($Q_a$') mit einer Basis, die mit dem Formungstreiber (10) verbunden ist, und einem Kollektor, der mit dem Kollektor des zweiten PNP-Transistors ($Q_s$') verbunden ist, um einen ansteigenden Impulsstrom in dem Moment zu erzeugen, in dem der zweite PNP-Transistor ($Q_s$') abgeschaltet wird, und den ansteigenden Impulsstrom dem Magnetkopf als einen Aufzeichnungsstrom zuzuführen; und

einen dritten NPN-Transistor ($Q_k$) mit einer Basis, die mit dem ersten Gleichspannungs-Zuführanschluss ($V^+$) verbunden ist, einem Kollektor, der mit den Emittern des ersten und des zweiten PNP-Transistors ($Q_a$, $Q_a$') verbunden ist, einem Emitter, der mit einem veränderbaren Widerstand ($R_k$) zum Steuern eines Stroms verbunden ist, der mit dem zweiten Gleichspannungs-Zuführanschluss ($V^-$) verbunden ist.

11. Magnetaufzeichnungsvorrichtung nach Anspruch 10, die des Weiteren umfasst:

einen Komparator (OP), der mit den Kollektoren des ersten und des zweiten NPN-Transistors ($Q_s$, $Q_s$') verbunden ist, um einen vorgegebenen Bezugswert mit einem Momentanwert eines Aufzeichnungsstroms ($I_r$) zu vergleichen, der sich aufgrund des Durchgangs des Aufzeichnungsstroms ($I_r$) durch einen Drehumformer geändert hat; und

einen Integrator ($R_c$, $C_c$), der den Ausgang des Komparators integriert und ein Kompensationssignal ($V_{cc}$) erzeugt.

12. Magnetaufzeichnungsvorrichtung nach Anspruch 10 oder Anspruch 11, wobei ein Übergangs-Impulsstrom so erzeugt wird, dass er Anstiegseigenschaften aufweist, die schnell verbessert werden, indem die Beträge der ersten und der zweiten Gleichspannung ($V^+$, $V^-$) reguliert werden, der erste bis dritte NPN-Transistor ($Q_a$, $Q_a$', $Q_k$) beim Umschalten der Polarität des Aufzeichnungsstroms ($I_r$) abgeschaltet werden, und eine Spannung, die der gesamten Energiequelle entspricht, an einen Magnetkopf (H'D) angelegt wird.

13. Magnetaufzeichnungsvorrichtung nach Anspruch 10, 11 oder 12, die des Weiteren umfasst:

eine erste Dämpfungsvorrichtung (D), deren eines Ende mit dem gemeinsamen Kollektor des ersten PNP-Transistors ($Q_s$) und des ersten NPN-Transistors ($Q_a$) verbunden ist, und deren anderes Ende mit dem ersten Gleichspannungs-Zuführanschluss ($V^+$) verbunden ist; und

eine zweite Dämpfungsvorrichtung (D'), deren eines Ende mit dem gemeinsamen Kollektor des zweiten PNP-Transistors ($Q_s$') und des zweiten NPN-Transistors ($Q_a$') verbunden ist, und deren anderes Ende mit dem ersten Gleichspannungs-Zuführanschluss ($V^+$) verbunden ist, wobei ein ansteigender Impulsstrom durch die erste und die zweite Dämpfungsvorrichtung (D, D') schnell in einen normalen Stromwert übergeht.

14. Magnetaufzeichnungsverfahren zum Aufzeichnen eines digitalen Signals auf ein Magnetaufzeichnungsmedium mit einem Aufzeichnungsstrom, der digitale Informationen anzeigt und einem Magnetkopf (H'D) zugeführt wird, wobei das Verfahren die folgenden Schritte umfasst:

Erzeugen positiver und negativer Signale, deren Polaritäten entsprechend den digitalen Informationen umgekehrt werden; und

Erzeugen eines Aufzeichnungsstroms ($I_r$), der den positiven und negativen Signalen entspricht,

Erzeugen eines Übergangs-Impulsstroms beim Umschalten der Polarität des Aufzeichnungsstroms ($I_r$) und

Zuführen des Übergangs-Impulsstroms zu dem Magnetkopf (H'D),

**dadurch gekennzeichnet, dass**:

das digitale Signal auf Basis des Übergangs-Impulsstroms auf das Magnetaufzeichnungsmedium (5) aufgezeichnet wird, wobei die Umschaltgeschwindigkeit des Aufzeichnungsstroms durch Verwendung dieses Übergangs-Impulsstroms erhöht wird.

**15.** Magnetaufzeichnungsverfahren nach Anspruch 14, das des Weiteren die folgenden Schritte umfasst:

Erzeugen eines Kompensationssignals ($V_{cc}$) für eine Änderung des Momentanwertes des Aufzeichnungsstroms ($I_r$); und

Steuern des Momentanwertes des Aufzeichnungsstroms ($I_r$) in Reaktion auf das Kompensationssignal ($V_{cc}$), so dass er konstant ist.

**Revendications**

**1.** Dispositif d'enregistrement magnétique pour enregistrer un signal numérique ($E_{io}$) en appliquant un courant d'enregistrement ($I_r$) indicatif d'informations numériques à une tête magnétique (H'D), comportant :

un circuit de commande de mise en forme (10) pour des signaux positif et négatif dont les polarités sont inversées, correspondant auxdites informations numériques,
des moyens symétriques (14) pour générer un courant d'enregistrement ($I_r$) correspondant auxdits signaux positif et négatif et générer un courant impulsionnel transitoire durant l'inversion de la polarité dudit courant d'enregistrement ($I_r$), et
des moyens de commutation de courant (12) pour commuter un courant circulant à travers lesdits moyens symétriques (14) en réponse auxdits signaux positif et négatif,

   **caractérisé en ce que** :

ledit signal numérique est enregistré sur ledit support d'enregistrement magnétique (5) sur la base dudit courant impulsionnel transitoire, et ainsi la vitesse de commutation du courant d'enregistrement est augmentée en utilisant ce courant impulsionnel transitoire.

**2.** Dispositif d'enregistrement magnétique selon la revendication 1, comportant en outre des moyens de commande de courant constant (16) pour commander tous les signaux de courant appliqués auxdits moyens symétriques (14) pour qu'ils soient constants.

**3.** Dispositif d'enregistrement magnétique selon la revendication 1, comportant en outre :

des moyens (20) pour générer un signal de compensation ($V_{cc}$) contre une variation de la valeur instantanée d'un courant d'enregistrement ($I_r$) généré dans lesdits moyens symétriques (14), et
des moyens de commande de courant constant (16) pour commander ladite valeur instantanée dudit courant d'enregistrement ($I_r$) pour qu'elle soit constante en réponse audit signal de compensation ($V_{cc}$).

**4.** Dispositif d'enregistrement magnétique selon la revendication 1, comportant :

une paire de commutateurs (SW, SW', $Q_s$, $Q_s'$) pour commuter les signaux de courant positif et négatif,
un premier dispositif d'amplification ($Q_a$) pour générer un courant d'enregistrement ($I_r$) correspondant à un signal de courant commuté par un commutateur de ladite paire de commutateurs (SW, $Q_s$) et générer un courant impulsionnel transitoire durant l'inversion de la polarité dudit courant d'enregistrement ($I_r$) de ladite tête magnétique (H'D),
un second dispositif d'amplification ($Q_a'$) pour générer un courant d'enregistrement ($I_r$) correspondant à un signal de courant commuté par l'autre commutateur (SW', $Q_s'$) et générer un courant impulsionnel transitoire durant l'inversion de la polarité dudit courant d'enregistrement ($I_r$) de ladite tête magnétique (H'D), et
un dispositif de commande de courant constant ($I_o$) pour commander un courant constant circulant à travers lesdits premier ($Q_a$) et second ($Q_a'$) dispositifs d'amplification.

**5.** Dispositif d'enregistrement magnétique selon la revendication 1, pour enregistrer un signal numérique en appliquant un courant d'enregistrement correspondant à des informations numériques via un transformateur rotatif à une tête magnétique et magnétiser un support d'enregistrement magnétique, comportant :

une paire de commutateurs (SW, SW', $Q_s$, $Q_s$') pour commuter les signaux de courant positif et négatif,
un premier dispositif d'amplification ($Q_a$) pour générer un courant d'enregistrement ($I_r$) correspondant à un signal de courant commuté par un commutateur de ladite paire de commutateurs (SW, $Q_s$) et générer un courant impulsionnel transitoire durant l'inversion de la polarité dudit courant d'enregistrement de ladite tête magnétique (H'D),
un second dispositif d'amplification ($Q_a$') pour générer un courant d'enregistrement correspondant à un signal de courant commuté par l'autre commutateur (SW', $Q_s$') et générer un courant impulsionnel transitoire durant l'inversion de la polarité dudit courant d'enregistrement ($I_r$) de ladite tête magnétique (H'D),
un générateur de signal de compensation (20, OP, $R_{ci}$, $R_{ci}$', $Q_c$, $R_c$, $C_c$) pour générer un signal de compensation ($V_{cc}$) sous la forme d'un signal de tension conformément à une variation de la valeur instantanée d'un courant d'enregistrement ($I_r$) généré, provoqué par le passage via ledit transformateur rotatif, et
un dispositif de commande de courant constant ($Q_k$) pour commander ladite valeur instantanée dudit courant d'enregistrement ($I_r$) pour qu'elle soit constante en réponse audit signal de compensation ($V_{cc}$),

dans lequel ledit courant impulsionnel transitoire circule à travers ladite tête magnétique (H'D) et un signal numérique est enregistré sur ledit support d'enregistrement magnétique.

6. Dispositif d'enregistrement magnétique selon la revendication 4 ou 5, comportant en outre :

un premier dispositif d'amortissement (D) ayant une extrémité insérée entre un commutateur de ladite paire de commutateurs ($Q_s$) et ledit premier dispositif d'amplification ($Q_a$), et l'autre extrémité connectée à une source d'énergie ($V^+$), et

un second dispositif d'amortissement (D') ayant une extrémité insérée entre l'autre commutateur ($Q_s$') et ledit second dispositif d'amplification ($Q_a$'), et l'autre extrémité connectée à ladite source d'énergie ($V^+$),
dans lequel ledit courant transitoire converge rapidement vers une valeur de courant normal par l'intermédiaire desdits premier et second dispositifs d'amortissement (D', D).

7. Dispositif d'enregistrement magnétique selon la revendication 1, comportant :

un premier dispositif à semi-conducteurs complémentaire ($Q_a$) pour générer un courant d'enregistrement correspondant audit signal positif et générer un courant impulsionnel transitoire durant l'inversion de la polarité dudit courant d'enregistrement de ladite tête magnétique,
un second dispositif à semi-conducteurs complémentaire ($Q_a$') connecté en parallèle audit premier dispositif à semi-conducteurs complémentaire, pour générer un courant impulsionnel transitoire durant l'inversion de la polarité dudit courant d'enregistrement de ladite tête magnétique, et
un dispositif de commande de courant constant ($Q_k$) connecté en commun auxdits premier et second dispositifs à semi-conducteurs complémentaires ($Q_a$, $Q_a$').

8. Dispositif d'enregistrement magnétique selon la revendication 7, comportant en outre :

un générateur de signal de compensation (20) pour générer un signal de compensation ($V_{cc}$) sous la forme d'un signal de tension conformément à une variation de la valeur instantanée d'un courant d'enregistrement ($I_r$) généré, provoqué par le passage via un transformateur rotatif.

9. Dispositif d'enregistrement magnétique selon la revendication 7 ou 8, comportant en outre :

un premier dispositif d'amortissement (D) ayant une extrémité connectée audit premier dispositif à semi-conducteurs complémentaire ($Q_a$), et l'autre extrémité connectée à une source d'énergie ($V^+$), et
un second dispositif d'amortissement (D') ayant une extrémité connectée audit second dispositif à semi-conducteurs complémentaire ($Q_a$'), et l'autre extrémité connectée à ladite source d'énergie ($V^+$),
dans lequel ledit courant transitoire converge rapidement vers une valeur de courant normal par l'intermédiaire desdits premier et second dispositifs d'amortissement (D, D').

10. Dispositif d'enregistrement magnétique selon la revendication 1, pour enregistrer un signal numérique en appliquant un courant d'enregistrement correspondant à des informations numériques à une tête magnétique et lire ledit signal numérique enregistré, comportant :

des première et seconde bornes d'alimentation de tension continue (DC) (V$^+$, V$^-$) pour recevoir des première et seconde tensions DC prédéterminées,

un premier transistor pnp (Q$_s$) ayant une base connectée audit circuit de commande de mise en forme (10) et un émetteur connecté à ladite première borne d'alimentation de tension DC (V$^+$), pour s'activer conformément audit signal négatif,

un second transistor pnp (Q$_s$') ayant une base connectée audit circuit de commande de mise en forme (10) et un émetteur connecté à ladite première borne d'alimentation de tension DC (V$^+$), pour s'activer conformément audit signal positif,

un premier transistor npn (Q$_a$) ayant une base connectée audit circuit de commande de mise en forme et un collecteur connecté au collecteur dudit premier transistor pnp (Q$_s$), pour générer un courant impulsionnel de flanc avant au moment où ledit premier transistor pnp (Q$_s$) est bloqué et appliquer ledit courant impulsionnel de flanc avant en tant que courant d'enregistrement à ladite tête magnétique,

un deuxième transistor npn (Q$_a$') ayant une base connectée audit circuit de commande de mise en forme (10) et un collecteur connecté au collecteur dudit second transistor pnp (Q$_s$'), pour générer un courant impulsionnel de flanc avant au moment où ledit second transistor pnp (Q$_s$') est bloqué et appliquer ledit courant impulsionnel de flanc avant en tant que courant d'enregistrement à ladite tête magnétique, et

un troisième transistor npn (Q$_k$) ayant une base connectée à la première borne d'alimentation de tension DC (V$^+$), un collecteur connecté en commun aux émetteurs desdits premier et deuxième transistors npn (Q$_a$, Q$_a$'), un émetteur connecté à une résistance variable (R$_k$) pour commander un courant qui est relié à ladite seconde borne d'alimentation de tension DC (V$^-$).

**11.** Dispositif d'enregistrement magnétique selon la revendication 10, comportant en outre :

un comparateur (OP) connecté aux collecteurs desdits premier et deuxième transistors npn (Q$_s$, Q$_s$'), pour comparer une valeur de référence prédéterminée à une valeur instantanée d'un courant d'enregistrement (I$_r$) changé du fait du passage dudit courant d'enregistrement (I$_r$) via un transformateur rotatif, et

un intégrateur (R$_c$, C$_c$) pour intégrer la sortie dudit comparateur et générer un signal de compensation (V$_{cc}$).

**12.** Dispositif d'enregistrement magnétique selon la revendication 10 ou 11, dans lequel un courant impulsionnel transitoire est généré pour avoir des caractéristiques de montée rapidement améliorées en ajustant les grandeurs desdites première et seconde tensions DC (V$^+$, V$^-$), bloquant lesdits premier à troisième transistors npn (Q$_a$, Q$_a$', Q$_k$) durant la commutation de la polarité dudit courant d'enregistrement (I$_r$), et appliquant une tension correspondant à toute la source d'énergie à une tête magnétique (H'D).

**13.** Dispositif d'enregistrement magnétique selon la revendication 10, 11 ou 12, comportant en outre :

un premier dispositif d'amortissement (D) ayant une extrémité connectée au collecteur commun dudit premier transistor pnp (Q$_s$) et dudit premier transistor npn (Q$_a$), et l'autre extrémité est connectée à ladite première borne d'alimentation de tension DC (V$^+$), et

un second dispositif d'amortissement (D') ayant une extrémité connectée au collecteur commun dudit second transistor pnp (Q$_s$') et dudit deuxième transistor npn (Q$_a$'), et l'autre extrémité connectée à ladite première borne d'alimentation de tension DC (V$^+$),

dans lequel un courant impulsionnel de flanc avant converge rapidement vers une valeur de courant normal par l'intermédiaire desdits premier et second dispositifs d'amortissement (D, D').

**14.** Procédé d'enregistrement magnétique pour enregistrer un signal numérique sur un support d'enregistrement magnétique par un courant d'enregistrement indicatif d'informations numériques appliqué à une tête magnétique (H'D), ledit procédé comportant les étapes consistant à :

générer des signaux positif et négatif dont les polarités sont inversées, correspondant auxdites informations numériques, et

générer un courant d'enregistrement (I$_r$) correspondant auxdits signaux positif et négatif, générer un courant impulsionnel transitoire durant la commutation de la polarité dudit courant d'enregistrement (I$_r$), et appliquer ledit courant impulsionnel transitoire à ladite tête magnétique (H'D),

**caractérisé en ce que** :

ledit signal numérique est enregistré sur ledit support d'enregistrement magnétique (5) sur la base dudit courant impulsionnel transitoire, ainsi la vitesse de commutation du courant d'enregistrement est augmentée en utilisant ce courant impulsionnel transitoire.

15. Procédé d'enregistrement magnétique selon la revendication 14, comportant en outre les étapes consistant à :

générer un signal de compensation ($V_{cc}$) contre une variation de la valeur instantanée dudit courant d'enregistrement ($I_r$), et
commander la valeur instantanée dudit courant d'enregistrement ($I_r$) pour être constant en réponse audit signal de compensation ($V_{cc}$).

EP 0 758 782 B1

# FIG. 1
# (PRIOR ART)

# FIG. 3
# (PRIOR ART)

# FIG. 2A
# (PRIOR ART)

# FIG. 2B
# (PRIOR ART)

# FIG. 2C
# (PRIOR ART)

# FIG. 2D
# (PRIOR ART)

# FIG. 4 (PRIOR ART)

# FIG. 5 (PRIOR ART)

FIG. 6A
(PRIOR ART)

$E_1$

FIG. 6B
(PRIOR ART)

$E_1'$

FIG. 6C
(PRIOR ART)

$I_a$

FIG. 6D
(PRIOR ART)

$I_a'$

FIG. 6E
(PRIOR ART)

$I_r$ , $I_h$

FIG. 7A (PRIOR ART)

FIG. 7B (PRIOR ART)

FIG. 7C (PRIOR ART)

FIG. 7D (PRIOR ART)

$i_R \fallingdotseq E_l / R_S$

EP 0 758 782 B1

FIG. 8A
(PRIOR ART)

FIG. 8B
(PRIOR ART)

FIG. 8C
(PRIOR ART)

FIG. 8D
(PRIOR ART)

FIG. 8E
(PRIOR ART)

FIG. 8F
(PRIOR ART)

# FIG. 9 (PRIOR ART)

# FIG. 10 (PRIOR ART)

# FIG. 11A (PRIOR ART)

# FIG. 11B (PRIOR ART)

# FIG. 12A (PRIOR ART)

# FIG. 12B (PRIOR ART)

EP 0 758 782 B1

EP 0 758 782 B1

# FIG. 13

SOURCE → SOURCE ENCODER ← CHANNEL-ENCODER ← RECORDING AMPLIFIER → H'D

1 2 3 4 5

# FIG. 14

CURRENT SWITCHING DEVICE — 12

INPUT PULSE → SHAPING DRIVER → PUSH-PULL AMPLIFIER → HEAD PORTION

10 14 18

CONSTANT CURRENT CONTROLLING DEVICE — 16

# FIG. 15

FIG. 16A — $E_{io}$

FIG. 16B — $E_i$

FIG. 16C — $E_i'$

FIG. 16D — $I_a , I_s'$

FIG. 16E — $I_a', I_s$

FIG. 16F — $I_K$

FIG. 16G — $I_r$

# FIG. 17

FIG. 18A

FIG. 18B

FIG. 18C

# FIG. 19A

# FIG. 19B

# FIG. 20A

# FIG. 20B

# FIG. 21A

# FIG. 21B

# FIG. 22A

# FIG. 22B

EP 0 758 782 B1

## FIG. 23A

## FIG. 23B

## FIG. 24A

R/T OUTPUT

## FIG. 24B

REC AMP
INPUT

## FIG. 24C

REC AMP OUTPUT
(HEAD CURRENT)

## FIG. 25

RECORDING AMPLIFIER EQUIVALENT CIRCUIT

P\T EQUIVALENT CIRCUIT

R\T EQUIVALENT CIRCUIT

HEAD EQUIVALENT CIRCUIT

## FIG. 26A

CURRENT $I_s$ OF CONSTANT CURRET SOURCE

## FIG. 26B

SYNTHESIZED EXCITING CURRET $I_{prt}$ OF P/T AND R/T

## FIG. 26C

HEAD CURRENT $I_h$

## FIG. 26D

HEAD LOSS CURRENT $I_{hr}$

## FIG. 26E

HEAD EXCITING CURRENT $I_{hi}$

# FIG. 27

ENERGY

$E_t$

ACCUMULATED
ENERGY OF
STARY
CAPACITANCE $C_s$

0    1    2    3    4    5    $t/\tau$

FIG. 28A

0    1

FIG. 28B

0    2

FIG. 28C

0    4

# FIG. 29

# FIG. 30

FIG. 31A $V_{ac}$

FIG. 31B $V_{ac}'$

FIG. 31C $V_{bc}$

FIG. 31D $V_{cc}$

$E_{CK}$

FIG. 31E $I_K$

0

I

FIG. 32

$(I_0 + I_{do}) \cdot (1 - \exp(-\gamma \cdot t))$

$(I_0 + I_{do})$

COMPENSATION CURRENT

1    2    3    4    5    $(t/\tau)$

$- I_{do} \cdot (1 - \exp(-\delta \cdot t))$

50